# EUROPÄISCHE PATENTSCHRIFT

(11) **EP 2 863 544 B1**
(45) Veröffentlichungstag und Bekanntmachung des Hinweises auf die Patenterteilung: **08.03.2017**
(21) Anmeldenummer: 14189313.1
(22) Anmeldetag: 17.10.2014
(51) Int. Cl.: H03H 7/46, H03H 7/01, H03F 3/21, H03F 1/52, H05H 7/02

(54) **Schaltungsanordnung und Vorrichtung zum Schutz eines elektronischen Bauteils**
Circuit assembly and device for protecting an electronic component
Agencement de couplage et dispositif de protection d'un composant électronique

(30) Priorität: 17.10.2013 DE 102013111470
(43) Veröffentlichungstag der Anmeldung: 22.04.2015
(73) Patentinhaber: Cryoelectra GmbH, 42287 Wuppertal (DE)
(72) Erfinder: Prof.Dr. Helmut Piel, 42287 Wuppertal (DE); Dipl.-Ing. Dr. Sergei Kolesov, 58285 Gevelsberg (DE)
(74) Vertreter: Cohausz & Florack

(56) Entgegenhaltungen:
- US-A- 4 003 005
- US-A1- 2002 149 445
- US-A1- 2004 207 483
- US-A1- 2004 222 184
- US-A1- 2012 105 149
- US-B1- 6 462 482
- ANDREI GREBENNIKOV ET AL: "High-efficiency balanced switched-path monolithic SiGe HBT power amplifiers for wireless applications", MICROWAVE INTEGRATED CIRCUIT CONFERENCE, 20007. EUMIC 2007. EUROPEAN, IEEE, PI, 1. Oktober 2007 (2007-10-01), Seiten 391-394, XP031197697, ISBN: 978-2-87487-002-6
- GASPAR M ET AL: "A compact 500MHz 4kW Solid-State Power Amplifier for accelerator applications", NUCLEAR INSTRUMENTS & METHODS IN PHYSICS RESEARCH. SECTION A: ACCELERATORS, SPECTROMETERS, DETECTORS, AND ASSOCIATED EQUIPMENT, ELSEVIER BV * NORTH-HOLLAND, NL, Bd. 637, Nr. 1, 15. Februar 2011 (2011-02-15), Seiten 18-24, XP028368177, ISSN: 0168-9002, DOI: 10.1016/J.NIMA.2011.02.057 [gefunden am 2011-02-20]
- AKHILESH JAIN ET AL: "Modular 20kW solid state RF amplifier for Indus-2 syncrotron radiation source", NUCLEAR INSTRUMENTS & METHODS IN PHYSICS RESEARCH. SECTION A: ACCELERATORS, SPECTROMETERS, DETECTORS, AND ASSOCIATED EQUIPMENT, ELSEVIER BV * NORTH-HOLLAND, NL, Bd. 676, 17. Februar 2012 (2012-02-17), Seiten 74-83, XP028478577, ISSN: 0168-9002, DOI: 10.1016/J.NIMA.2012.02.023 [gefunden am 2012-02-27]

## Beschreibung

### Gebiet der Erfindung

Die vorliegende Erfindung betrifft unter anderem eine Schaltungsanordnung und Vorrichtungen zum Schutz eines elektronischen Bauteils, insbesondere eines Hochfrequenz-Bauteils (z.B. einer Verstärkereinheit eines HF-Verstärkers oder eines VHF-Verstärkers).

### Hintergrund der Erfindung

Die Beschleunigung von Elektronen, Protonen und schweren Ionen auf hohe Energien oberhalb von einigen MeV geschieht ausnahmslos in den Hohlraumresonatoren (engl. Cavities) eines Teilchenbeschleunigers. Zur Erregung der elektromagnetischen Felder in diesen Beschleunigungsresonatoren und zur Übertragung von Energie auf die zu beschleunigenden Elektronen, Protonen und Ionen, sowie deren Antiteilchen werden Hochfrequenzverstärker im HF-Bereich von ca. 30 MHz bis ca. 3 GHz (insbesondere im VHF-Bereich von ca. 30 MHz bis ca. 300 MHz benötigt, die eine Hochfrequenzleistung von ca.
10 kW bis zu mehreren MW erzeugen können.

Bis vor wenigen Jahren konnten diese Leistungen nur mit Röhrenverstärkern erreicht werden. Die Erfolge in der Entwicklung von LDMOS-FET (Laterally Diffused Metal Oxide Semiconductor- Field Effect Transistor) Leistungstransistoren haben dazu geführt, dass heute VHF-Halbleiterverstärker bis zu Leistungen im 10 bis 150 kW-Bereich und darüber hinaus gebaut werden können.

### Zusammenfassung einiger beispielhafter Ausführungsformen der vorliegenden Erfindung

In den Hochfrequenzresonatoren von Beschleunigeranlagen können elektromagnetische Störungen auftreten, welche Störsignale bzw. elektromagnetische Impulse erzeugen, deren Partialwellen Frequenzen aufweisen, die oberhalb und/oder unterhalb der Betriebsfrequenz des Beschleunigungsresonators liegen, die vom Beschleunigungsresonator in Richtung auf die aktiven Leistungstransistoren emittiert werden und diese gegebenenfalls zerstören können. Diese Zerstörung wird vornehmlich durch zu hohe Spannungsamplituden der Störsignale bewirkt (z.B. Störsignale mit Spannungsamplituden größer als oder gleich 130 V, insbesondere mit Spannungsamplituden größer als oder gleich 150 V). Impuls-Spannungsamplituden von mehr als 130 V und einer Dauer von wenigen Pikosekunden können auf Leistungstransistoren eines HF-Verstärkers wie LDMOS-Feldeffekt-Transistoren zerstörend einwirken.

Diese Störungen werden insbesondere durch sich selbst erhaltende Gasentladungen (Lichtbögen) in Beschleunigungsresonatoren hervorgerufen. Die in der elektrischen Energietechnik bei Schalthandlungen auftretenden Lichtbögen werden als "Schaltlichtbögen" und unerwünschte Lichtbögen werden als "Störlichtbögen" bezeichnet. Solche Störlichtbögen können auch in Beschleunigerresonatoren entstehen.

Es liegt in der Natur von Beschleunigungsresonatoren, dass es in ihrem Inneren Zonen mit hoher elektrischer Feldstärke gibt. Zur Vermeidung von Störlichtbögen muss daher ein sehr gutes Vakuum im Resonator aufrechterhalten werden. Zu einer lokalen Druckerhöhung im Resonator und damit zur Schaffung der nötigen Voraussetzung für die Erzeugung einer sich selbst erhaltenden Gasentladung und eine Störlichtbogens kann es jedoch während des Hochfeldbetriebs durch die Feldemission von Elektronen oder durch sogenanntes Electron-Multipacting kommen.

In beiden Prozessen kommt es zur Erzeugung von Strömen aus freien Elektronen, die im Feld des Resonators beschleunigt werden und dadurch Energie aufnehmen. Beim Auftreffen dieser Elektronenströme auf die Wand des Resonators treten lokale Erwärmungen auf. Hierdurch werden auf der Resonatorwand adsorbierte Schichten (vornehmlich Wasserschichten) verdampft und erzeugen das nötige Gas, in dem es zu einer sich selbst erhaltenden Gasentladung (also einem Lichtbogen) kommen kann. Die beiden Prozesse, bei denen es zu freien Strömen im Resonator kommen kann werden im Folgenden kurz dargestellt.

Das Phänomen der Erzeugung freier Elektronenströme durch Multipacting tritt in der Regel bereits bei niedrigen Feldstärken in einem Beschleunigungsresonator auf.

Es gibt zwei Kategorien des Electron-Multipacting: Das einseitige und das zweiseitige Multipacting, deren Beschreibung im Einzelnen den Rahmen dieser Anmeldung übersteigen würde. Ein Electron-Multipacting-Ereignis beginnt mit der Auslösung eines Elektrons aus der Kupferwand des Resonators, typischerweise durch kosmische Strahlung. Das aus dem Metall austretende Elektron wird im Feld des Resonators beschleunigt und trifft im Fall des zweiseitigen Multipacting auf die gegenüber liegende Wand des Resonators. Ist seine Energie beim Eindringen in das Metall größer als etwa 20 eV, so kann es mehrere Elektronen aus dem Metall auslösen. Falls sich zu diesem Zeitpunkt die Richtung des elektrischen Feldes an der Metalloberfläche umgedreht hat, so werden die ausgelösten Elektronen auf den Austrittsort des ursprünglichen Elektrons zurück beschleunigt und lösen dort wiederum Elektronen aus. Wenn die Flugzeit der Elektronen zwischen diesen beiden Orten gerade gleich (2n-1)*t/2 ist, wobei n eine ganze Zahl und t die Periodendauer des Hochfrequenzfeldes ist, so werden die erzeugten Elektronen wiederum beschleunigt und lösen wiederum beim Eindringen in das Metall Sekundärelektronen aus.

Als Folge dieser Lawinenentwicklung entsteht ein signifikanter Strom, welcher die beiden betroffenen kleinen Oberflächenzonen stark erwärmt. Diese Erwärmung kann, wie oben beschrieben, das Verdampfen von Schichten, die an jeder Metalloberfläche haften (insbesondere Wasserschichten), hervorrufen, was letztendlich über eine Verschlechterung des lokalen Vakuums zu einer Gasentladung führen kann, in deren Folge ein Störlichtbogen entstehen kann. Dies setzt jedoch voraus, dass sich der Multipacting-Prozess in einer Zone des Resonators abspielt, in der eine elektrische Feldstärke herrscht, bei der es zu einer selbsttragenden Gasentladung und damit zu einem Störlichtbogen kommen kann. Freie Elektronenströme entziehen jedoch in jedem Fall dem Resonator-Feld Energie und führen so zu einer Reduktion der Resonatorgüte. Dies führt wiederum zu einer Fehlanpassung des Resonators und dadurch zur Reflexion der angebotenen Hochfrequenzleistung. Gegen die Reflexion eines Teils ihres Ausgangssignals sind zumindest die oben bereits erwähnten LDMOS-Feldeffekt Transistoren jedoch weitgehend unempfindlich.

Die Erzeugung eines Störlichtbogens wird insbesondere bei hohen Feldstärken durch Elektronen-Feldemission im Resonator hervorgerufen. Feldemission von Elektronen aus Metalloberflächen tritt bevorzugt an mikroskopischen Spitzen auf der Metalloberfläche des Re-Resonators auf. Dabei wächst der Feldemissionsstrom exponentiell mit der Feldstärke im Resonator. Der auf der dem Feldemitter gegenüberliegenden Wand des Resonators auftreffende Feldemissionsstrom führt zu der oben bereits beschriebenen Vakuumverschlechterung und dadurch zur Voraussetzung für eine Gasentladung, die mit zunehmendem Emissionsstrom und zunehmenden Druck zu einem Lichtbogen (z.B. einem Störlichtbogen) führen kann. Über den geringen Widerstand des Plasmas im Lichtbogen entlädt sich die gesamte Energie des Resonators in einer sehr kurzen Zeitspanne. Der Feldzusammenbruch erzeugt ein Störsignal der Dauer Δt, welches über die Ankopplung des Resonators an die HF-Versorgungsleitung auf den HF-Verstärker zurückläuft.

Besonders gefährlich sind die hierdurch erzeugten Störsignale zum Einen wegen ihrer willkürlichen Phasenlage im Verhältnis zu der Phase der vom Verstärker gelieferten Speiseleistung und zum Anderen durch ihre nicht vorhersagbaren Spannungsspitzen, die zur Zerstörung der Leistungstransistoren führen können.

Ein extrem kurzzeitiges Signal, das durch einen Feldzusammenbruch im Resonator erzeugt wird, ist kein harmonisches Signal. Es handelt sich um ein Wellenpaket, welches die Bedingung Δν·Δt≥1 erfüllt, wobei ν die Frequenz der Partialwellen des Wellenpakets ist. Geeigneter erscheint die Bezeichnung elektromagnetischer Impuls oder schlicht Impuls für das Wellenpaket, das durch einen plötzlichen Zusammenbruch des elektromagnetischen Feldes im Beschleunigungsresonator erzeugt wird. Bezeichnet man mit ν₁ die obere Frequenz, bei der die Amplitude des Impulses auf etwa die Hälfte ihres Maximalwertes abgefallen ist, und ν₂ als die untere Frequenz, bei der die Amplitude des Impulses auf die Hälfte ihres Maximalwerts gesunken ist, so ist Δν die Differenz dieser beiden Größen oder die Breite des Frequenzintervalls. Das Gleichheitszeichen in der oben genannten Bedingung (Δν·Δt≥1) ist dann korrekt, wenn der Impuls ein Rechteckimpuls ist und alle Partialwellen die gleiche Amplitude haben. Dies ist bei einem durch einen Feldzusammenbruch erzeugten Impuls nicht der Fall. Die Bezeichnung dieses Ereignisses als Impuls, der vom Beschleunigungsresonator auf den Verstärker reflektiert wird, ist ungenau, da es sich nicht um eine Reflexion des vom Verstärker gesendeten Signals, sondern um eine spontane Emission des Beschleunigungsresonators handelt. Je kürzer also die Dauer Δt des Zusammenbruchs ist, umso größer ist das Frequenzintervall Δν. Es entstehen also Partialwellen, deren Frequenzen sowohl oberhalb als auch unterhalb der Resonanzfrequenz des Resonators liegen können.

Denkbar wäre der Schutz der Leistungstransistoren vor diesen Störsignalen durch einen Zirkulator, der die von einer Last ausgehenden Hochfrequenzsignale in einen Lastwiderstand leitet. Zirkulatoren nutzen den Faraday-Effekt der Drehung der Polarisationsrichtung einer Welle bei deren Durchgang durch einen magnetisierten Ferriten. Die Drehung der Polarisationsebene wird durch das Produkt aus Länge des Weges der Welle im Ferriten, der Größe des Magnetfeldes und dem Betrag der Verdet'schen Konstante bestimmt. Die Verdet'sche Konstante wird bei Frequenzen unter 300 MHz umso stärker temperaturabhängig je tiefer die Frequenz ist. Aus diesem Grund müssen Zirkulatoren insbesondere im unteren HF-Bereich mit einer aktiven Temperaturregelung ausgerüstet sein.

HF-Halbleiterverstärker für den unteren HF-Bereich sind deshalb äußerst schwierig zu realisieren und ausgesprochen kostspielig.

Aus der Patentanmeldung US 2002/0149445 A1 ist unter anderem eine Vorrichtung mit einem sogenannten "dual directional harmonics dissipation filter" mit einem Eingangs- und einem Ausgangsanschluss bekannt. Der Eingangsanschluss dieser Vorrichtung ist mit einem RF-Leistungsverstärker verbunden ist, der ein RF-Signal in einem vorgegebenen Frequenzbereich bereitstellt, und der Ausgangsanschluss ist mit einer Plasmakammer verbunden und stellt das RF-Signal in dem vorgegebenen Frequenzbereich für die Plasmakammer bereit. Zwischen dem Ein- und Ausgangsanschluss ist ein Tiefpassfilter gekoppelt, und an das Tiefpassfilter sind eine Mehrzahl von Hochpassfiltern gekoppelt. Die Hochpassfilter erhalten harmonische Signale, die den vorgegebenen Frequenzbereich überschreiten, und absorbieren diese.

In dem Patent US 4,003,005 wird unter anderem eine bidirektionale Filterschaltung mit einem Eingang und einem Ausgang und über einen gewünschten Frequenzbereich im Wesentlichen konstanten Ein- und Ausgangs-Impedanzcharakteristiken beschrieben.

Die Patentanmeldung US 2004/0207483 beschreibt unter anderem einen dualen Diplexer mit einem Tiefpassfilter, das einen Anschluss CH1 und einen Anschluss CH2 verbindet, einem ersten Hochpassfilter, das den Anschluss CH1 mit einem Anschluss CH3 verbindet, und einem zweiten Hochpassfilter, das den Anschluss CH2 mit einem Anschluss CH4 verbindet.

In dem Artikel "A compact 500 MHz 4kw Solid-state Power Amplifier for accelerator applications" (Gaspar, M., et al. "A compact 500MHz 4kW Solid-State Power Amplifier for accelerator applications." Nuclear Instruments and Methods in Physics Research Section A: Accelerators, Spectrometers, Detectors and Associated Equipment 637.1 (2011): 18-24) wird ein schmalbandiger Festkörper-Leistungsverstärker vorgestellt. Als Anwendungsbereich für einen solchen Festkörper-Leistungsverstärker werden Beschleuniger für eine neue Generation von Synchrotronlichtquellen genannt.

Der Artikel "Modular 20 kW solid state RF amplifier for Indus-2 syncrotron radiation source" (Jain, Akhilesh, et al. "Modular 20kW solid state RF amplifier for Indus-2 syncrotron radiation source." Nuclear Instruments and Methods in Physics Research Section A: Accelerators, Spectrometers, Detectors and Associated Equipment 676 (2012): 74-83.) beschreibt das Design und die Entwicklung eines 505,8 MHz modularen Festkörper-RF-Verstärkers, der 20 kW kontinuierliche RF-Leistung zur Verfügung stellen kann. Dieser Verstärker wurde als RF-Leistungsquelle einer Indus-2 Synchrotronstrahlungsquelle in Auftrag gegeben.

Es ist u.a. eine Aufgabe der vorliegenden Erfindung, die oben beschriebenen Nachteile zu überwinden.

Diese Aufgabe wird gelöst durch ein System nach Anspruch 1 und eine Verwendung nach Anspruch 12. Vorteilhafte Ausführungsformen sind den abhängigen Patentansprüchen zu entnehmen.

Den im Folgenden beschriebenen erfindungsgemäßen Ausführungsformen und Ausführungsbeispielen ist unter anderem gemeinsam, dass sie den Schutz von Bauelementen eines

HF-Bauteils (z.B. einer Verstärkereinheit eines HF-Verstärkers, insbesondere eines VHF-Verstärkers) zumindest vor in den Ausgang des HF-Bauteils laufenden Störsignalen ermöglichen.

Das erfindungsgemäße System umfasst eine Vorrichtung, insbesondere einen VHF-Verstärker oder ein Verstärkermodul für einen VHF-Verstärker, umfassend einen oder mehrere Verstärkerzweige, und einen Teilchenbeschleuniger, wobei ein Beschleunigungsresonator des Teilchenbeschleunigers mit einem Ausgang der Vorrichtung verbunden ist, wobei jeder Verstärkerzweig der Vorrichtung eine Schaltungsanordnung und eine Verstärkereinheit umfasst, und wobei die Schaltungsanordnung umfasst eine Durchgangsfilterstrecke zwischen einem ersten Ein- und/oder Ausgangsknoten und einem zweiten Ein- und/oder Ausgangsknoten, wobei in der Durchgangsfilterstrecke ein Durchgangsfilter mit Tiefpasscharakteristik oder Bandpasscharakteristik angeordnet ist, eine erste Absorptionsfilterstrecke zwischen dem zweiten Ein- und/oder Ausgangsknoten und einem dritten Knoten, wobei in der ersten Absorptionsfilterstrecke ein erstes Hochpassfilter angeordnet ist, und wobei an dem dritten Knoten ein erster Lastwiderstand angeordnet ist, und eine zweite Absorptionsfilterstrecke zwischen dem ersten Ein- und/oder Ausgangsknoten und einem vierten Knoten, wobei in der zweiten Absorptionsfilterstrecke ein zweites Hochpassfilter angeordnet ist, und wobei an dem vierten Knoten ein zweiter Lastwiderstand angeordnet ist.

Die im Folgenden beschriebenen Ausführungsformen und Ausführungsbeispiele einer erfindungsgemäßen Schaltungsanordnung und einer erfindungsgemäßen Vorrichtung sollen jeweils als Beschreibung einer Schaltungsanordnung und/oder einer Vorrichtung gemäß dem erfindungsgemäßen System verstanden werden.

Die erfindungsgemäße Schaltungsanordnung umfasst beispielsweise ein Netzwerk diskreter und/oder integrierter elektronischer Bauteile. Der erste Ein- und/oder Ausgangsknoten, der zweite Ein- und/oder Ausgangsknoten, der dritte Knoten und der vierte Knoten sind zum Beispiel voneinander verschiedene Netzwerkknoten eines Netzwerks der erfindungsgemäßen Schaltungsanordnung. Der erste Ein- und/oder Ausgangsknoten und der zweite Ein- und/oder Ausgangsknoten sind zum Beispiel als Anschlussklemmen ausgeführt. Sie dienen beispielsweise als Ein- und/oder Ausgang der Schaltungsanordnung.

Die Durchgangsfilterstrecke soll insbesondere als elektrische Verbindung zwischen dem ersten Ein- und/oder Ausgangsknoten und dem zweiten Ein- und/oder Ausgangsknoten verstanden werden. Zum Beispiel ist die Durchgangsfilterstrecke die einzige elektrische Verbindung zwischen dem ersten Ein- und/oder Ausgangsknoten und dem zweiten Ein- und/oder Ausgangsknoten.

Die erste Absorptionsfilterstrecke (bzw. die zweite Absorptionsfilterstrecke) soll dementsprechend insbesondere als elektrische Verbindung zwischen dem zweiten Ein- und/oder Ausgangsknoten (bzw. dem ersten Ein- und/oder Ausgangsknoten) und dem dritten Knoten (bzw. dem vierten Knoten) verstanden werden. Zum Beispiel ist die erste Absorptionsfilterstrecke (bzw. die zweite Absorptionsfilterstrecke) die einzige elektrische Verbindung zwischen dem zweiten Ein- und/oder Ausgangsknoten (bzw. dem ersten Ein- und/oder Ausgangsknoten) und dem dritten Knoten (bzw. dem vierten Knoten).

In der Durchgangsfilterstrecke kann ein Durchgangsfilter mit einer Tiefpasscharakteristik, also ein Tiefpassfilter bzw. ein Mittel zur Tiefpassfilterung eines Signals angeordnet sein. Dadurch wird beispielsweise eine Tiefpassfilterung eines entlang der Durchgangsfilterstrecke (d.h. vom ersten Ein- und/oder Ausgangsknoten oder dem zweiten Ein- und/oder Ausgangsknoten zu dem anderen Ein- und/oder Ausgangsknoten) übertragenen Signals erreicht. Insbesondere kann dadurch die Übertragung von (unerwünschten) höherfrequenten Signalanteilen (d.h. insbesondere Signalanteilen mit Frequenzen oberhalb des Durchlassbandes des Durchgangsfilters, z.B. entsprechenden Störsignalanteilen eines Störsignals von einer Last) entlang der Durchgangsfilterstrecke zumindest im Wesentlichen verhindert bzw. gedämpft werden.

Alternativ kann in der Durchgangsfilterstrecke ein Durchgangsfilter mit einer Bandpasscharakteristik, also ein Bandpassfilter bzw. ein Mittel zur Bandpassfilterung eines Signals angeordnet sein. Dadurch wird beispielsweise eine Bandpassfilterung eines entlang der Durchgangsfilterstrecke (d.h. vom ersten Ein- und/oder Ausgangsknoten oder dem zweiten Ein- und/oder Ausgangsknoten zu dem anderen Ein- und/oder Ausgangsknoten) übertragenen Signals erreicht. Insbesondere kann dadurch die Übertragung von (unerwünschten) höherfrequenten und niederfrequenten Signalanteilen (d.h. insbesondere Signalanteilen mit Frequenzen ober- und unterhalb des Durchlassbandes des Durchgangsfilters, z.B. entsprechenden Störsignalanteilen eines Störsignals) entlang der Durchgangsfilterstrecke zumindest im Wesentlichen verhindert bzw. gedämpft werden. Ein Durchgangsfilter mit einer Bandpasscharakteristik kann zum Beispiel durch die Hintereinanderschaltung eines Tiefpassfilters und eines Hochpassfilters gebildet werden.

In der ersten Absorptionsfilterstrecke ist ein erstes Hochpassfilter und in der zweiten Absorptionsfilterstrecke ist ein zweites Hochpassfilter, also Mittel zur Hochpassfilterung eines Signals angeordnet. Dadurch wird beispielsweise eine Hochpassfilterung eines entlang der ersten Absorptionsfilterstrecke (d.h. vom zweiten Ein- und/oder Ausgangsknoten zum dritten Knoten) bzw. der zweiten Absorptionsfilterstrecke (d.h. vom ersten Ein- und/oder Ausgangsknoten zum vierten Knoten) übertragenen Signals erreicht. Insbesondere kann dadurch die Übertragung von niederfrequenten Signalanteilen (d.h. insbesondere Signalanteilen mit Frequenzen unterhalb des Durchlassbandes der Hochpassfilter) entlang der Absorptionsfilterstrecken zumindest im Wesentlichen verhindert bzw. gedämpft werden. Das erste und das zweite Hochpassfilter sind unterschiedliche Baugruppen. Sie können beispielsweise die gleiche oder eine unterschiedliche Filtercharakteristik aufweisen. Zum Beispiel können das erste und das zweite Hochpassfilter identisch aufgebaut sein. Es ist jedoch beispielsweise auch denkbar, dass sie unterschiedlich aufgebaut sind.

Sowohl die erste als auch die zweite Absorptionsfilterstrecke sind durch einen an dem dritten bzw. an dem vierten Knoten angeordneten Lastwiderstand abgeschlossen. Der erste und der zweite Lastwiderstand dienen zum Beispiel zur möglichst vollständigen Absorption eines entlang der ersten bzw. zweiten Absorptionsfilterstrecke übertragenen Signals, beispielsweise in Form einer Absumpfung.

Durch diesen Aufbau wirkt die erfindungsgemäße Schaltungsanordnung sowohl für an dem ersten Ein- und/oder Ausgangsknoten als auch an dem zweiten Ein- und/oder Ausgangsknoten angelegten Signale als Diplexer. Die erfindungsgemäße Schaltungsanordnung wird demnach als bidirektionaler Diplexer oder Bidiplexer bezeichnet und stellt ein neuartiges Bauteil dar. Sie eignet sich vorteilhafterweise zur Schutzbeschaltung am Ausgang eines HF-Bauteils (z.B. einer Verstärkereinheit eines HF-Verstärkers, insbesondere eines VHF-Verstärkers). So kann sie unter anderem einen Schutz des HF-Bauteils vor in den Ausgang reflektierten Oberwellen des Ausgangssignals des HF-Bauteils und vor in den Ausgang emittierten höherfrequenten und ggf. niederfrequenten Störsignalanteilen eines Störsignals einer am Ausgang befindlichen Last, beispielsweise eines Resonators, insbesondere eines Beschleunigungsresonators eines Teilchenbeschleunigers, bewirken.

Gemäß der Erfindung wird deshalb vorgeschlagen, die erfindungsgemäße Schaltungsanordnung zwischen den Ausgang einer Verstärkereinheit eines Verstärkers (z.B. eines HF-Halbleiterverstärkers, insbesondere eines VHF-Halbleiterverstärkers) eines Teilchenbeschleunigers und den Beschleunigungsresonator des Teilchenbeschleunigers zum Schutz des Leistungstransistors der Verstärkereinheit vor einem Störsignal des Beschleunigungsresonators zu schalten.

Zum Beispiel liegen das Ausgangssignal der Verstärkereinheit am ersten Ein- und/oder Ausgangsknoten und das Störsignal vom Beschleunigungsresonator am zweiten Ein- und/oder Ausgangsknoten der erfindungsgemäßen Schaltungsanordnung an. Die erfindungsgemäße Schaltungsanordnung ermöglicht in diesem Beispiel zumindest einen zweifachen Schutz des Leistungstransistors der Verstärkereinheit: im zweiten Lastwiderstand werden die Oberwellen des Ausgangssignals der Verstärkereinheit zumindest im Wesentlichen absorbiert, so dass eine Reflexion der Oberwellen in Richtung der Verstärkereinheit größtenteils vermieden wird, und im ersten Lastwiderstand werden die höherfrequenten Störsignalanteile des Störsignals vom Beschleunigungsresonator zumindest im Wesentlichen absorbiert, so dass diese Störsignalanteile die Verstärkereinheit gar nicht oder nur gedämpft erreichen. Ferner kann das Durchgangsfilter mit Bandpasscharakteristik auch die Übertragung von niederfrequenten Störsignalanteilen des Störsignals vom Beschleunigungsresonator dämpfen.

Das Ausgangssignal der Verstärkereinheit ist nicht frei von Oberwellen. Die in diesen Oberwellen enthaltene Leistung ist nutzlos und kann in der erfindungsgemäßen Schaltungsanordnung von der Grundwelle zumindest im Wesentlichen getrennt und in einem Lastwiderstand (z.B. dem zweiten Lastwiderstand) absorbiert werden. Diese Leistung kann somit auch nicht auf den Leistungstransistor zurück reflektiert werden, wodurch eine schädliche, zusätzliche Erwärmung des Sperrbezirks (Junction) des Leistungstransistors der Verstärkereinheit vermieden wird.

Wie bereits oben erläutert, können im Beschleunigungsresonator eines Teilchenbeschleunigers beispielsweise durch freie Elektronenströme Störlichtbögen und damit Störsignale mit hoher Spannungsamplitude (z.B. Störsignale mit Spannungsamplituden größer als oder gleich 130 V, insbesondere mit Spannungsamplituden größer als oder gleich 150 V) entstehen, die in Halbleiterverstärkern zur Zerstörung der Leistungstransistoren führen können. In der erfindungsgemäßen Schaltungsanordnung können zumindest die höherfrequenten Störsignalanteile dieser Störsignale des Beschleunigungsresonators nicht nur reflektiert und gedämpft werden, wie beim einfachen Diplexer. Vielmehr können diese höherfrequenten Störsignalanteile zumindest im Wesentlichen einem Lastwiderstand (z.B. dem zweiten Lastwiderstand) reflexionsfrei zugeführt und dort absorbiert werden.

Die durch diesen unerwünschten Betriebszustand erzeugte Gefahr für den Verstärker wird durch den Einsatz der erfindungsgemäßen Schaltungsanordnung stark reduziert. Die erfindungsgemäße Schaltungsanordnung wirkt als Leistungsteiler für die Störsignale vom Beschleunigungsresonator. Die Absorption der höherfrequenten Störsignalanteile des Störsignals vom Beschleunigungsresonator ist umso effektiver, je höher die Frequenz des Störsignalanteils über der Grundfrequenz der Grundwelle des Ausgangssignals der Verstärkereinheit liegt.

Der Vorteil des erfindungsgemäßen Bidiplexers (d.h. der erfindungsgemäßen Schaltungsanordnung) liegt insbesondere darin, dass sowohl die vom Verstärker erzeugten Oberwellen als auch die vom Resonator emittierte Leistung bzw. Störsignalanteile der vom Resonator emittierten Störsignale mit hoher Spannungsamplitude gedämpft werden.

Zum Beispiel sind das Durchgangsfilter und das zweite Hochpassfilter derart ausgebildet, dass die Grundwelle des Ausgangssignals der Verstärkereinheit zumindest im Wesentlichen entlang der Durchgangsfilterstrecke übertragen wird, wohingegen Oberwellen (mit Frequenzen, die ein ganzzahliges Vielfaches der Frequenz der Grundwelle betragen) des Ausgangssignals der Verstärkereinheit (z.B. die Oberwellen mit einer höheren Frequenz als die Grundfrequenz der Grundwelle des Ausgangssignals der Verstärkereinheit) zumindest im Wesentlichen entlang der zweiten Absorptionsfilterstrecke übertragen und anschließend in dem zweiten Lastwiderstrand zumindest im Wesentlichen absorbiert werden. Ferner ist das erste Hochpassfilter beispielsweise derart ausgebildet, dass höherfrequente Störsignalanteile des Störsignals vom Beschleunigungsresonator (z.B. die Störsignalanteile des Störsignals mit einer höheren Frequenz als die Grundfrequenz der Grundwelle des Ausgangssignals der Verstärkereinheit) zumindest im Wesentlichen entlang der ersten Absorptionsfilterstrecke übertragen und anschließend in dem ersten Lastwiderstand zumindest im Wesentlichen absorbiert werden, aber zumindest im Wesentlichen keine Übertragung der Grundwelle des Ausgangssignals der Verstärkereinheit entlang der ersten Absorptionsfilterstrecke stattfindet. Dabei soll unter der Übertragung eines Signals bzw. eines Signalanteils zumindest im Wesentlichen entlang einer Strecke insbesondere verstanden werden, dass zumindest 90%, vorzugsweise zumindest 95% der Leistung des Signals bzw. des Signalanteils entlang dieser Strecke übertragen werden sollen. Eine Übertragung von 90% der Leistung eines Signals entlang einer Strecke entspricht einer Dämpfung des Signals bei der Übertragung von ca. -0,46 dB.

Die erfindungsgemäße Schaltungsanordnung lässt sich ausschließlich mit passiven elektronischen Bauelementen realisieren, insbesondere ist keine aufwändige (aktive) Temperaturregelung erforderlich. Sie ist daher einfach und kostengünstig herstellbar. Die erfindungsgemäße Schaltungsanordnung eignet sich daher besonders vorteilhaft zum Einsatz in HF-Halbleiterverstärkem eines Teilchenbeschleunigers (insbesondere in VHF-Halbleiterverstärkern eines Teilchenbeschleunigers) anstelle der bislang verwendeten Zirkulatoren.

Gemäß einem Ausführungsbeispiel der erfindungsgemäßen Schaltungsanordnung sind das Durchgangsfilter und/oder das erste Hochpassfilter und/oder das zweite Hochpassfilter Filter zweiter oder höherer Ordnung, vorzugsweise dritter Ordnung. Zum Beispiel können diese Filter als aktive und/oder passive Filter realisiert sein, beispielsweise als Butterworth-Filter, Sallen-Key-Filter, Elliptisches Filter oder Tschebyscheff-Filter. Durch die Verwendung Filter zweiter oder höherer Ordnung wird eine bessere Dämpfung der unerwünschten Signalanteile jenseits der Grenzfrequenz erreicht.

Gemäß einem Ausführungsbeispiel der erfindungsgemäßen Schaltungsanordnung sind das Durchgangsfilter und/oder das erste Hochpassfilter und/oder das zweite Hochpassfilter passive Filter.

Gemäß einem Ausführungsbeispiel der erfindungsgemäßen Schaltungsanordnung wird das Durchgangsfilter, insbesondere das Durchgangsfilter mit Tiefpasscharakteristik, durch mindestens zwei Spulen und mindestens einen Kondensator in T-Schaltung gebildet. Zum Beispiel kann die Induktivität der mindestens zwei Spulen in dem Durchgangsfilter jeweils 90 nH und die Kapazität des mindestens einen Kondensators in dem Durchgangsfilter 43 pF betragen. Alternativ ist beispielsweise auch denkbar, dass das Durchgangsfilter, insbesondere das Durchgangsfilter mit Tiefpasscharakteristik, durch mindestens zwei Kondensatoren und mindestens eine Spule in PI-Schaltung gebildet wird. Ferner können beispielsweise weitere Bauelemente oder Bauelementegruppen zur Bildung des Durchgangsfilters herangezogen werden.

Gemäß einem Ausführungsbeispiel der erfindungsgemäßen Schaltungsanordnung werden das erste und/oder das zweite Hochpassfilter jeweils durch mindestens zwei Kondensatoren und mindestens eine Spule in T-Schaltung gebildet. Zum Beispiel kann die Induktivität der mindestens einen Spule in dem ersten und dem zweiten Hochpassfilter 36 nH, die Kapazität einer der mindestens zwei Kondensatoren in dem ersten und dem zweiten Hochpassfilter 16 pF betragen und die Kapazität des anderen der mindestens zwei Kondensatoren in dem ersten und dem zweiten Hochpassfilter 22 pF betragen. Alternativ ist beispielsweise auch denkbar, dass das erste und/oder zweite Hochpassfilter durch mindestens zwei Spulen und mindestens einen Kondensator in PI-Schaltung gebildet wird. Ferner können beispielsweise weitere Bauelemente oder Bauelementegruppen zur Bildung des ersten oder des zweiten Hochpassfilters herangezogen werden, wie zum Beispiel eine zusätzliche Spule in Reihenschaltung mit der T-Schaltung aus den mindestens zwei Kondensatoren und der mindestens einen Spule.

Gemäß einem Ausführungsbeispiel der erfindungsgemäßen Schaltungsanordnung ist das Durchgangsfilter mit Tiefpasscharakteristik derart gebildet ist, dass seine Grenzfrequenz größer als eine vorgegebene Grundfrequenz (auch als erste Harmonische bezeichnet, f) einer Grundwelle und kleiner als die Frequenz (2f) der zweiten Harmonischen der Grundwelle ist, und das erste und das zweite Hochpassfilter sind jeweils derart gebildet, dass ihre jeweilige Grenzfrequenz größer als die vorgegebene Grundfrequenz (f) der Grundwelle und kleiner als die Frequenz (2f) der zweiten Harmonischen der Grundfrequenz ist.

Als Grenzfrequenz soll insbesondere die Frequenz verstanden werden, bei der die Leistung des Ausgangssignals eines Filters auf die Hälfte der Leistung des Eingangssignals des Filters zurückgeht, also eine Dämpfung um -3 dB eintritt. Die Grenzfrequenz des Durchgangsfilters mit Tiefpasscharakteristik ist beispielsweise die obere Grenze des Durchlassbandes des Durchgangsfilters mit Tiefpasscharakteristik. Die Grenzfrequenz des Durchgangsfilters mit Tiefpasscharakteristik beträgt beispielsweise 150%, vorzugsweise 125%, besonders vorzugsweise 110% der Grundfrequenz der Grundwelle. Die vorgegebene Grundfrequenz der Grundwelle liegt vorzugsweise im Durchlassband des Durchgangsfilters mit Tiefpasscharakteristik. Dadurch werden höherfrequente Störsignalanteile eines Störsignals (d.h. insbesondere Störsignalanteile des Störsignals mit Frequenzen oberhalb des Durchlassbandes des Durchgangsfilters mit Tiefpasscharakteristik, z.B. Störsignalanteile des Störsignals mit Frequenzen, die größer oder gleich 150%, vorzugsweise größer oder gleich 125%, besonders vorzugsweise größer oder gleich 110% der Grundfrequenz der Grundwelle sind) gar nicht oder nur stark gedämpft von dem ersten Ein- und/oder Ausgangsknoten oder dem zweiten Ein- und/oder Ausgangsknoten zu dem anderen Ein- und/oder Ausgangsknoten übertragen.

Beim Einsatz der erfindungsgemäßen Schaltungsanordnung in einem HF-Verstärker eines Teilchenbeschleunigers entspricht die vorgegebene Grundfrequenz zum Beispiel der Grundfrequenz der Grundwelle des Ausgangssignals der Verstärkereinheit des HF-Verstärkers (z.B. 72 MHz). Dadurch wird es ermöglicht, dass die Grundwelle des Ausgangssignals der Verstärkereinheit nahezu ungedämpft von dem ersten Ein- und/oder Ausgangsknoten oder dem zweiten Ein- und/oder Ausgangsknoten zu dem anderen Ein- und/oder Ausgangsknoten übertragen wird. Die Oberwellen des Ausgangssignals (d.h. die zweite und höhere Harmonische der Grundwelle des Ausgangssignals) und die höherfrequenten Störsignalanteile des Störsignals vom Beschleunigungsresonator (d.h. insbesondere Störsignalanteile des Störsignals mit Frequenzen oberhalb des Durchlassbandes des Durchgangsfilters mit Tiefpasscharakteristik, z.B. Störsignalanteile des Störsignals mit Frequenzen, die größer oder gleich 150%, vorzugsweise größer oder gleich 125%, besonders vorzugsweise größer oder gleich 110% der Grundfrequenz der Grundwelle sind) werden dagegen nur stark gedämpft von dem ersten Ein- und/oder Ausgangsknoten oder dem zweiten Ein- und/oder Ausgangsknoten zu dem anderen Ein- und/oder Ausgangsknoten übertragen. Stattdessen werden die Oberwellen des Ausgangssignals und die höherfrequenten Störsignalanteile des Störsignals vom Beschleunigungsresonator nahezu ungedämpft entlang der ersten bzw. der zweiten Absorptionsfilterstrecke übertragen und in dem ersten bzw. zweiten Lastwiderstand möglichst vollständig absorbiert, so dass diese Signale nur stark gedämpft von der erfindungsgemäßen Schaltungsanordnung durchgelassen werden.

Zum Beispiel können das Durchgangsfilter und das erste und das zweite Hochpassfilter derart gebildet sein, dass die Grundwelle des Ausgangssignals der Verstärkereinheit bei der Übertragung von dem ersten Ein- und/oder Ausgangsknoten oder dem zweiten Ein- und/oder Ausgangsknoten zu dem anderen Ein- und/oder Ausgangsknoten um nicht mehr als -0,5 dB gedämpft wird, wohingegen die 2. Harmonische der Grundwelle des Ausgangssignals der Verstärkereinheit um mindestens -10 dB und die 3. Harmonische der Grundwelle des Ausgangssignals der Verstärkereinheit um mindestens -25 dB gedämpft werden. Ferner können das Durchgangsfilter und das erste und das zweite Hochpassfilter derart gebildet sein, dass das von der erfindungsgemäßen Schaltungsanordnung reflektierte Signal um mindestens -20 dB gedämpft wird.

Gemäß einem Ausführungsbeispiel der erfindungsgemäßen Schaltungsanordnung ist das Durchgangsfilter mit Bandpasscharakteristik derart gebildet, dass seine untere Grenzfrequenz kleiner als eine vorgegebene Grundfrequenz (auch als erste Harmonische bezeichnet, f) einer Grundwelle und seine obere Grenzfrequenz größer als eine vorgegebene Grundfrequenz (f) einer Grundwelle und kleiner als die Frequenz der zweiten Harmonischen (2f) der Grundwelle ist, und das erste und das zweite Hochpassfilter sind jeweils derart gebildet, dass ihre jeweilige Grenzfrequenz größer als die vorgegebene Grundfrequenz (f) der Grundwelle und kleiner als die Frequenz (2f) der zweiten Harmonischen der Grundfrequenz ist.

Die obere Grenzfrequenz des Durchgangsfilters mit Bandpasscharakteristik ist beispielsweise die obere Grenze des Durchlassbandes des Durchgangsfilters mit Bandpasscharakteristik und die untere Grenzfrequenz des Durchgangsfilters mit Bandpasscharakteristik ist die untere Grenze des Durchlassbandes des Durchgangsfilters mit Bandpasscharakteristik. Die vorgegebene Grundfrequenz der Grundwelle liegt vorzugsweise im Durchlassband des Durchgangsfilters mit Bandpasscharakteristik. Die obere Grenzfrequenz des Durchgangsfilters mit Bandpasscharakteristik beträgt beispielsweise 150%, vorzugsweise 120%, besonders vorzugsweise 110% der Grundfrequenz der Grundwelle. Die untere Grenzfrequenz des Durchgangsfilters mit Bandpasscharakteristik beträgt beispielsweise 50%, vorzugsweise 75%, besonders vorzugsweise 90% der Grundfrequenz der Grundwelle. Wie oben erwähnt, entspricht die vorgegebene Grundfrequenz beim Einsatz der erfindungsgemäßen Schaltungsanordnung in einem HF-Verstärker zum Beispiel der Grundfrequenz der Grundwelle des Ausgangssignals der Verstärkereinheit (z.B. 72 MHz).

Dadurch werden höherfrequente und niederfrequente Störsignalanteile des Störsignals (d.h. insbesondere Störsignalanteile des Störsignals mit Frequenzen oberhalb und unterhalb des Durchlassbandes des Durchgangsfilters mit Bandpasscharakteristik, z.B. Störsignalanteile des Störsignals mit Frequenzen, die größer oder gleich 150%, vorzugsweise größer oder gleich 125%, besonders vorzugsweise größer oder gleich 110% der Grundfrequenz der Grundwelle und die kleiner oder gleich 50%, vorzugsweise kleiner oder gleich 75%, besonders vorzugsweise kleiner oder gleich 90% der Grundfrequenz der Grundwelle sind) gar nicht oder nur stark gedämpft von dem ersten Ein- und/oder Ausgangsknoten oder dem zweiten Ein- und/oder Ausgangsknoten zu dem anderen Ein- und/oder Ausgangsknoten übertragen.

Gemäß einem Ausführungsbeispiel der erfindungsgemäßen Schaltungsanordnung entsprechen der erste und zweite Lastwiderstand jeweils dem Wellenwiderstand, insbesondere dem Wellenwiderstand der verwendeten Leitungen, insbesondere dem Wellenwiderstand der verwendeten Leitungen bei der Grundfrequenz der Grundwelle des Ausgangssignals der Verstärkereinheit. Übliche Leitungen haben beispielsweise einen Wellenwiderstand von 50 Ω oder 75 Ω. Durch die Verwendung des Wellenwiderstands als Lastwiderstand soll eine Reflexion der entlang der ersten bzw. zweiten Absorptionsfilterstrecke übertragenen Signale bzw. Signalanteile verhindert werden.

Eine erste erfindungsgemäße Vorrichtung, insbesondere ein erfindungsgemäßes Verstärkermodul für einen Verstärker (z.B. für einen HF-Verstärker, insbesondere für einen VHF-Verstärker), umfasst einen oder mehrere Verstärkerzweige, wobei jeder Verstärkerzweig die erfindungsgemäße Schaltungsanordnung und eine Verstärkereinheit, insbesondere eine Halbleiterverstärkereinheit, umfasst.

Gemäß einem Ausführungsbeispiel der ersten erfindungsgemäßen Vorrichtung ist der Ausgang der Verstärkereinheit an einem der Ein- und/oder Ausgangsknoten der erfindungsgemäßen Schaltungsanordnung angeordnet. Insbesondere kann die erfindungsgemäße Schaltungsanordnung zwischen die Verstärkereinheit und einen Ausgang des Verstärkerzweigs geschaltet werden. Dadurch kann ein Schutz der Verstärkereinheit zumindest vor vom Ausgang des Verstärkerzweigs bzw. von einem Ausgang der Vorrichtung in Richtung der Verstärkereinheit laufenden höherfrequenten (und ggf. niederfrequenten) Störsignalanteilen eines Störsignals bewirkt werden. Dies können beispielsweise von einer Last (z.B. einem Beschleunigungsresonator) abgegebene Störsignale mit hoher Spannungsamplitude (z.B. Störsignale mit Spannungsamplituden größer als oder gleich 130 V, insbesondere mit Spannungsamplituden größer als oder gleich 150 V) sein, die durch die erfindungsgemäße Schaltungsanordnung zumindest teilweise gedämpft und/oder absorbiert werden. Des Weiteren kann durch die erfindungsgemäße Schaltungsanordnung eine Reflexion der Oberwellen des Ausgangssignals der Verstärkereinheit zurück auf die Verstärkereinheit vermieden werden.

Gemäß einem Ausführungsbeispiel der ersten erfindungsgemäßen Vorrichtung werden jeweils die Ausgangssignale zweier oder mehrerer Verstärkerzweige der ein oder mehreren Verstärkerzweige durch einen Signal-Kombinierer, insbesondere einen 90°-Hybrid-Combiner, zu einem Signal zusammengefasst. Der Signal-Kombinierer ist beispielsweise ein Signal-Kombinierer einer ersten Stufe von Signal-Kombinierern. Das Signal ist zum Beispiel ein Ausgangssignal des Signal-Kombinierers, zum Beispiel ein Ausgangssignal einer ersten Stufe von Signalkombinieren. Gleichzeitig kann das Signal aber auch ein Eingangssignal für einen zweiten Signal-Kombinierer und/oder andere Bauelemente und/oder das Ausgangssignal der Vorrichtung sein. Die Ausgangssignale zweier oder mehrerer Signal-Kombinierer der ersten Stufe können zum Beispiel jeweils durch einen Signal-Kombinierer einer zweiten Stufe, insbesondere einen 90°-Hybrid-Combiner, zu einem Signal (zum Beispiel einem Ausgangssignal der zweiten Stufe von Signal-Kombinieren) zusammengefasst werden.

Zum Beispiel kann der Signal-Kombinierer oder können die Signal-Kombinierer zwischen die Verstärkerzweige und einen Ausgang der Vorrichtung geschaltet werden.

Beispiele für einen Signal-Kombinierer (Combiner) sind, wie weiter unten beschrieben, ein Wilkinson-Combiner und ein Hybrid-Combiner, insbesondere ein 90°-Hybrid-Combiner.

Eine zweite erfindungsgemäße Vorrichtung, insbesondere ein erfindungsgemäßes Verstärkermodul für einen Verstärker (z.B. für einen HF-Verstärker, insbesondere für einen VHF-Verstärker), umfasst einen oder mehrere Verstärkerzweige, wobei jeder Verstärkerzweig eine Verstärkereinheit umfasst, wobei jeweils die Ausgangssignale zweier oder mehrerer Verstärkerzweige der ein oder mehreren Verstärkerzweige durch einen Signal-Kombinierer, insbesondere einen 90°-Hybrid-Combiner, zu einem Signal zusammengefasst werden. Der Signal-Kombinierer ist beispielsweise ein Signal-Kombinierer einer ersten Stufe von Signal-Kombinierern. Das Signal ist zum Beispiel ein Ausgangssignal des Signal-Kombinierers, zum Beispiel ein Ausgangssignal einer ersten Stufe von Signalkombinieren. Gleichzeitig kann das Signal aber auch ein Eingangssignal für einen zweiten Signal-Kombinierer und/oder andere Bauelemente und/oder das Ausgangssignal der Vorrichtung sein. Die Ausgangssignale zweier oder mehrerer Signal-Kombinierer der ersten Stufe können zum Beispiel jeweils durch einen Signal-Kombinierer einer zweiten Stufe, insbesondere einen 90°-Hybrid-Combiner, zu einem Signal (zum Beispiel einem Ausgangssignal der zweiten Stufe von Signal-Kombinieren) zusammengefasst werden.

Zum Beispiel kann der Signal-Kombinierer oder können die Signal-Kombinierer zwischen die Verstärkerzweige und einen Ausgang der Vorrichtung geschaltet werden.

Beispiele für einen solchen Signal-Kombinierer (Combiner) sind ein Wilkinson-Combiner und ein Hybrid-Combiner, insbesondere ein 90°-Hybrid-Combiner.

90°-Hybrid-Combiner haben eine hervorragende Anpassung (engl. matching) des gemeinsamen Ausgangstors (engl. common port) sowohl im Fall der Abstimmung der individuellen Halbleiterverstärkereinheiten bzw. Verstärkerzweige auf maximale Ausgangsleistung, auf maximalen Wirkungsgrad als auch auf maximale Verstärkung. Außerdem haben 90°-Hybrid-Combiner eine sehr geringe Reduzierung der Isolation zwischen den einzelnen Halbleiterverstärkern bzw. Verstärkerzweigen im Falle einer schlecht angepassten Last am Ausgangstor (engl. mismatched common Port) sowie eine größere Robustheit (engl. immunity) der Halbleiterverstärkereinheiten bzw. Verstärkerzweige durch ihre Kombination in einem 90°-Hybrid-Combiner als im Fall eines alleinstehenden Halbleiterverstärkers bzw. Verstärkerzweigs.

Wilkinson-Combiner, deren Ausgangstor auf eine 50 Ω Last angepasst ist, fordern eine Anpassung der zu kombinierenden Halbleiterverstärkereinheiten bzw. Verstärkerzweige auf 50 , andernfalls ist eine Kombination nach Wilkinson ineffektiv. Eine Veränderung der Anpassung geschieht aber, falls die Halbleiterverstärkereinheiten bzw. Verstärkerzweige in unterschiedlichen Betriebszuständen betrieben werden. Außerdem kann es bei Wilkinson-Combinern zu einer Reduzierung der Isolation zwischen den Eingangstoren kommen, falls es zu einer Fehlanpassung des Ausgangstors kommt. Ein Vorteil der Wilkinson Combiner liegt in dem symmetrischen Aufbau und in der Einfachheit des Designs.

Insbesondere aufgrund der kapazitiven Durchgänge sind 90°-Hybrid-Combiner schmalbandiger als Wilkinson-Combiner. Sie haben also eine bandpassartigere Übertragungsfunktion als Wilkinson-Combiner. Durch die Zwischenschaltung von entsprechend angepassten 90°-Hybrid-Combinern zwischen die Verstärkereinheiten und den Ausgang kann daher ein Schutz vor vom Ausgang der Vorrichtung in Richtung der Verstärkereinheit laufenden höherfrequenten und niederfrequenten Störsignalanteilen eines Störsignals bewirkt werden. Dies können beispielsweise von einer Last (z.B. einem Beschleunigungsresonator) in den Ausgang abgegebene Störsignale mit hoher Spannungsamplitude (z.B. Störsignale mit Spannungsamplituden größer als oder gleich 130 V, insbesondere mit Spannungsamplituden größer als oder gleich 150 V) sein, die zumindest teilweise durch die bandpassartigere Übertragungsfunktion der 90°-Hybrid-Combiner gedämpft werden.

Ein Verstärkermodul ist beispielsweise die kleinste modulare und/oder austauschbare Einheit eines Verstärkers, zum Beispiel eines erfindungsgemäßen Verstärkers.
Ein Verstärkermodul umfasst beispielsweise zumindest vier Verstärkerzweige und zumindest zwei Stufen von Combinern.

Ein erfindungsgemäßer Verstärker, zum Beispiel ein erfindungsgemäßer HF-Verstärker, insbesondere ein erfindungsgemäßer VHF-Verstärker, umfasst eine oder mehrere der ersten und/oder zweiten erfindungsgemäßen Vorrichtungen.

Eine dritte erfindungsgemäße Vorrichtung, insbesondere ein erfindungsgemäßer Verstärker (z.B. ein erfindungsgemäßer HF-Verstärker, insbesondere ein erfindungsgemäßer VHF-Verstärker), umfasst einen oder mehrere Verstärkerzweige, wobei jeder Verstärkerzweig eine Verstärkereinheit umfasst, einen Ausgang, und ein oder mehrere Schutzfilter, wobei das eine oder die mehreren Schutzfilter zwischen die Verstärkereinheiten der Verstärkerzweige und den Ausgang geschaltet sind.

Der Ausgang ist der Ausgang der Vorrichtung, zum Beispiel der Verstärkerausgang eines erfindungsgemäßen Verstärkers.

Die Verstärkereinheit eines Verstärkerzweigs der dritten erfindungsgemäßen Vorrichtung (und auch der ersten und zweiten erfindungsgemäßen Vorrichtung) umfasst beispielsweise eine Transistorschaltungsanordnung mit mindestens einem Leistungstransistor, z.B. einem MOSFET (Metal Oxide Semiconductor Field Effect Transistor) Transistor und/oder einem LDMOS (Laterally Diffused Metal Oxide Semiconductor) Transistor. Ein Beispiel für einen geeigneten LDMOS Transistor ist der Transistor BLF 574 von NXP. Vorzugsweise ist die Transistorschaltungsanordnung als Gegentakt-Transistorverstärkerschaltung bzw. als Gegentakt-Transistorverstärkerschaltungsanordnung gebildet. Eine Halbleiterverstärkereinheit zeichnet sich beispielsweise dadurch aus, dass zumindest der Leistungstransistor bzw. die Leistungstransistoren, vorzugsweise die gesamte Transistorschaltungsanordnung in Halbleiterbauweise (z.B. als integrierter Schaltkreis) gebildet sind. Die Verstärkereinheit betrifft neben der Halbleiterverstärkereinheit beispielsweise auch Ausführungsformen in anderer Bauweise und/oder mit diskreten Bauteilen.

Die Grundfrequenz der Grundwelle des Ausgangssignals der Verstärkereinheit liegt beispielsweise im HF-Bereich, zum Beispiel im VHF-Bereich, vorzugsweise zwischen 30 MHz und 150 MHz, besonders vorzugsweise zwischen 30 MHz und 100 MHz. Zum Beispiel beträgt die Grundfrequenz der Grundwelle des Ausgangssignals der Verstärkereinheit 72 MHz.

Zwischen den Ausgängen der Verstärkereinheiten der Verstärkerzweige und dem Ausgang besteht vorzugsweise eine elektrische Verbindung, zum Beispiel über die Schutzfilter und ggf. einen oder mehrere Stufen von Signal-Kombinierern und/oder weitere Bauelemente.

Zum Beispiel sind die Schutzfilter derart zwischen die Verstärkereinheiten der Verstärkerzweige und den Ausgang geschaltet, dass die Schutzfilter vom Ausgang auf die Verstärkereinheiten zulaufende Signale filtern (d.h. zumindest Signalanteile dieser Signale dämpfen). Dadurch kann ein Schutz der Verstärkereinheiten zumindest vor vom Ausgang in Richtung der Verstärkereinheit laufenden Störsignalanteilen eines Störsignals, insbesondere Störsignalanteile des Störsignals mit Frequenzen außerhalb des Durchlassbandes der Schutzfilter bewirkt, werden. Dies können beispielsweise von einer Last (z.B. einem Beschleunigungsresonator) in den Ausgang abgegebene Störsignale mit hoher Spannungsamplitude (z.B. Störsignale mit Spannungsamplituden größer als oder gleich 130 V, insbesondere mit Spannungsamplituden größer als oder gleich 150 V) sein, die zumindest teilweise durch das Schutzfilter gedämpft werden.

Gemäß einem Ausführungsbeispiel der dritten erfindungsgemäßen Vorrichtung sind die Schutzfilter als Hochpassfilter und/oder als Bandpassfilter gebildet. Die Schutzfilter können demnach eine Hochpasscharakteristik und/oder eine Bandpasscharakteristik aufweisen. Vorzugsweise sind die Schutzfilter identisch gebildet. Es ist aber auch denkbar, dass unterschiedliche Schutzfilter verwendet werden.

Die Grenzfrequenz eines als Hochpassfilter gebildeten Schutzfilters kann beispielsweise kleiner als eine vorgegebene Grundfrequenz einer Grundwelle sein. Die Grenzfrequenz eines als Hochpassfilter gebildeten Schutzfilters beträgt beispielsweise 50%, vorzugsweise 75%, besonders vorzugsweise 90% der Grundfrequenz der Grundwelle. Die untere Grenzfrequenz eines als Bandpassfilters gebildeten Schutzfilters kann beispielsweise kleiner als eine vorgegebene Grundfrequenz einer Grundwelle und die obere Grenzfrequenz größer als eine vorgegebene Grundfrequenz einer Grundwelle sein. Die untere Grenzfrequenz eines als Bandpassfilter gebildeten Schutzfilters beträgt beispielsweise 50%, vorzugsweise 75%, besonders vorzugsweise 90% der Grundfrequenz der Grundwelle. Die obere Grenzfrequenz eines als Bandpassfilter gebildeten Schutzfilters beträgt beispielsweise 150%, vorzugsweise 125%, besonders vorzugsweise 110% der Grundfrequenz der Grundwelle. Vorzugsweise liegt die Grundfrequenz der Grundwelle im Durchlassband des Schutzfilters. Vorzugsweise entspricht die vorgegebene Grundfrequenz der Grundfrequenz der Grundwelle des Ausgangssignals der Verstärkereinheiten (z.B. 72 MHz).

Die Schutzfilter sind beispielsweise Filter erster Ordnung, vorzugsweise Filter zweiter oder höherer Ordnung. Zum Beispiel können diese Filter als aktive und/oder passive Filter realisiert sein, beispielsweise als Butterworth-Filter, Sallen-Key-Filter, Elliptisches Filter oder Tschebyscheff-Filter. Durch die Verwendung Filter zweiter oder höherer Ordnung wird eine bessere Dämpfung der Störsignalanteile des Störsignals jenseits der Grenzfrequenz erreicht.

Ein Schutzfilter, insbesondere ein als Hochpassfilter gebildetes Schutzfilter kann beispielsweise zumindest durch zwei Kondensatoren und eine Spule in T-Schaltung gebildet werden. Zum Beispiel haben die Kondensatoren eine Kapazität von 47,5 pF und die Spule eine Induktivität von 107 nH, so dass die Grenzfrequenz des Schutzfilters ca. 65 MHz (also ca. 87% von 72 MHz) beträgt. Ein solches Schutzfilter erster Ordnung weist eine Dämpfung von ca. -6 dB bei 40 MHz, ca. -14 dB bei 30 MHz, ca. -25 dB bei 20 MHz, ca. -44 dB bei 10 MHz und ca. -62 dB bei 5 MHz auf. Alternativ ist beispielsweise auch denkbar, dass ein als Hochpassfilter gebildetes Schutzfilter durch mindestens zwei Spulen und mindestens einen Kondensator in PI-Schaltung gebildet wird. Ferner können beispielsweise weitere Bauelemente oder Bauelementegruppen zur Bildung des zusätzlichen Hochpassfilters herangezogen werden. Ein als Bandpassfilter gebildetes Schutzfilter kann beispielsweise durch die Hintereinanderschaltung eines Hochpassfilter und eines Tiefpassfilters gebildet werden.

Falls die Schutzfilter als Hochpassfilter gebildet sind, wird durch die Schutzfilter ein Schutz der Verstärkereinheiten zumindest vor vom Ausgang in Richtung der Verstärkereinheit laufenden niederfrequenten Störsignalanteilen eines Störsignals (d.h. insbesondere Störsignalanteilen des Störsignals mit Frequenzen unterhalb des Durchlassbandes des Schutzfilters, z.B. Störsignalanteile des Störsignals mit Frequenzen, die kleiner oder gleich 50%, vorzugsweise kleiner oder gleich 75%, besonders vorzugsweise kleiner oder gleich 90% der Grundfrequenz der Grundwelle sind) bewirkt. Falls die Schutzfilter als Bandpassfilter gebildet sind, wird durch die Schutzfilter ein Schutz der Verstärkereinheit zumindest vor vom Ausgang in Richtung der Verstärkereinheit laufenden niederfrequenten und höherfrequenten Störsignalanteilen eines Störsignals (d.h. insbesondere Störsignalanteilen des Störsignals mit Frequenzen unterhalb und oberhalb des Durchlassbandes des zusätzlichen Bandpassfilters, z.B. Störsignalanteile des Störsignals mit Frequenzen, die größer oder gleich 150%, vorzugsweise größer oder gleich 125%, besonders vorzugsweise größer oder gleich 110% der Grundfrequenz der Grundwelle und die kleiner oder gleich 50%, vorzugsweise kleiner oder gleich 75%, besonders vorzugsweise kleiner oder gleich 90% der Grundfrequenz der Grundwelle sind) bewirkt. Dies können beispielsweise von einer Last (z.B. einem Beschleunigungsresonator) in den Ausgang abgegebene Störsignale sein.

Gemäß einem Ausführungsbeispiel der dritten erfindungsgemäßen Vorrichtung umfasst jeder Verstärkerzweig ferner eine erfindungsgemäße Schaltungsanordnung oder einen Diplexer.

Zum Beispiel kann eine erfindungsgemäße Schaltungsanordnung in jedem der Verstärkerzweige zwischen die Verstärkereinheit und einen Ausgang des Verstärkerzweigs geschaltet sein. Zum Beispiel sind der Ausgang der Verstärkereinheit mit einem der Ein- und/oder Ausgangsknoten der erfindungsgemäßen Schaltungsanordnung und der andere Ein- und/oder Ausgangsknoten der erfindungsgemäßen Schaltungsanordnung mit dem Ausgang des Verstärkerzweigs bzw. dem Ausgang der Vorrichtung elektrisch verbunden. Insbesondere kann die erfindungsgemäße Schaltungsanordnung zwischen die Verstärkereinheit und den Ausgang des Verstärkerzweigs bzw. den Ausgang der Vorrichtung geschaltet sein. Dadurch kann unter anderem ein zusätzlicher Schutz der Verstärkereinheit vor vom Ausgang in Richtung der Verstärkereinheit laufenden höherfrequenten (und ggf. niederfrequenten) Störsignalanteilen eines Störsignals bewirkt werden. Des Weiteren kann durch die erfindungsgemäße Schaltungsanordnung eine Reflexion der Oberwellen des Ausgangssignals der Verstärkereinheit zurück auf die Verstärkereinheit vermieden werden.

Zum Beispiel kann ein Diplexer in jedem der Verstärkerzweige zwischen die Verstärkereinheit und einen Ausgang des Verstärkerzweigs geschaltet sein.

Ein Diplexer ist im Allgemeinen ein Multiplexer, der einen Eingang mit zwei Ausgängen verbindet. Er ist eine Frequenzweiche und dient zur Entkopplung zweier Frequenzbereiche. Zum Beispiel kann der Diplexer in dem erfindungsgemäßen Verstärker zur Trennung einer Grundwelle von den Oberwellen der Grundwelle (z.B. der zweiten Harmonischen der Grundwelle und den höheren Harmonischen der Grundwelle) dienen. Zum Beispiel sind der Ausgang der Verstärkereinheit mit dem Eingang des Diplexers und ein Ausgang des Diplexers mit dem Ausgang des Verstärkerzweigs bzw. dem Verstärkerausgang elektrisch verbunden. Insbesondere kann der Diplexer zwischen die Verstärkereinheit und einen Ausgang des Verstärkerzweigs bzw. den Verstärkerausgang geschaltet sein.

Vorzugsweise kann der Diplexer in der dritten erfindungsgemäßen Vorrichtung die Durchgangsfilterstrecke und die zweite Absorptionsfilterstrecke mit dem zweiten Lastwiderstand entsprechend der erfindungsgemäßen Schaltungsanordnung umfassen, so dass er sich durch das Fehlen der ersten Absorptionsfilterstrecke mit dem ersten Lastwiderstand von der erfindungsgemäßen Schaltungsanordnung und deren oben beschriebenen Ausführungsbeispielen unterscheidet. In diesem Beispiel könnte der Ausgang der Verstärkereinheit mit dem ersten Ein- und/oder Ausgangsknoten des Diplexers und der zweite Ein- und/oder Ausgangsknoten des Diplexers mit dem Ausgang des Verstärkerzweigs bzw. dem Ausgang der Vorrichtung elektrisch verbunden sein.

Wie oben beschrieben, ist das Durchgangsfilter der Durchgangsfilterstrecke zum Beispiel derart ausgebildet, dass die Grundwelle des Ausgangssignals der Verstärkereinheit zumindest im Wesentlichen entlang der Durchgangsfilterstrecke übertragen wird, und das zweite Hochpassfilter der zweiten Absorptionsfilterstrecke ist beispielsweise derart ausgebildet, dass Oberwellen des Ausgangssignals der Verstärkereinheit (z.B. die Oberwellen mit einer höheren Frequenz als die Grundfrequenz der Grundwelle des Ausgangssignals der Verstärkereinheit) im Wesentlichen entlang der zweiten Absorptionsfilterstrecke übertragen und anschließend in dem zweiten Lastwiderstrand zumindest im Wesentlichen absorbiert werden. Demnach kann durch den Diplexer unter anderem eine Reflexion der Oberwellen des Ausgangssignals der Verstärkereinheit zurück auf die Verstärkereinheit vermieden werden.

Gemäß einem Ausführungsbeispiel der dritten erfindungsgemäßen Vorrichtung umfasst die dritte erfindungsgemäße Vorrichtung ferner eine erste Stufe von Signal-Kombinierern, wobei die erste Stufe von Signal-Kombinierern einen oder mehrere Signal-Kombinierer, insbesondere einen oder mehrere 90°-Hybrid-Combiner, umfasst, wobei die Signal-Kombinierer der ersten Stufe von Signal-Kombinieren zwischen die Verstärkerzweige und den Verstärkerausgang geschaltet sind. Zum Beispiel sind die Signal-Kombinierer der ersten Stufe von Signal-Kombinieren derart zwischen die Verstärkerzweige und den Verstärkerausgang geschaltet, dass jeweils die Ausgangssignale zweier oder mehrerer Verstärkerzweige der ein oder mehreren Verstärkerzweige durch einen Signal-Kombinierer der ersten Stufe von Signal-Kombinieren, insbesondere einen 90°-Hybrid-Combiner, zu einem Signal zusammengefasst werden. Das Signal ist zum Beispiel ein Ausgangssignal des Signal-Kombinierers, zum Beispiel ein Ausgangssignal einer ersten Stufe von Signalkombinieren. Gleichzeitig kann das Signal aber auch ein Eingangssignal für einen zweiten Signal-Kombinierer und/oder andere Bauelemente und/oder das Ausgangssignal der Vorrichtung sein. Die Ausgangssignale zweier oder mehrerer Signal-Kombinierer der ersten Stufe können zum Beispiel jeweils durch einen Signal-Kombinierer einer zweiten Stufe, insbesondere einen 90°-Hybrid-Combiner, zu einem Signal (zum Beispiel einem Ausgangssignal der zweiten Stufe von Signal-Kombinieren) zusammengefasst werden.

Beispiele für einen solchen Signal-Kombinierer (Combiner) sind, wie oben beschrieben, ein Wilkinson-Combiner und ein Hybrid-Combiner, insbesondere ein 90°-Hybrid-Combiner.

Zum Beispiel kann die dritte erfindungsgemäße Vorrichtung (und auch die erste und zweite erfindungsgemäße Vorrichtung) mehrere Stufen von solchen Combinern umfassen, bevorzugt zumindest zwei Stufen von Combinern, besonders bevorzugt zumindest drei Stufen von Combinern. Dies ist beispielsweise sinnvoll, um die Ausgangssignale (bzw. Ausgangsleistung) mehrerer Verstärkerzweige zu einem Ausgangssignal (bzw. einer Ausgangsleistung) der Vorrichtung zusammenzufassen. Eine Verstärkereinheit eines Verstärkerzweigs ist dann beispielsweise über die Schutzfilter und die Stufen von Combinern mit dem Ausgang elektrisch verbunden.

Zum Beispiel kann die dritte erfindungsgemäße Vorrichtung (und auch die erste und zweite erfindungsgemäße Vorrichtung) zumindest zwei Stufen von Combinern (z.B. von Hybrid-Combinern) umfassen, wobei die Combiner der ersten Stufe jeweils die Ausgangssignale zumindest zweier Verstärkerzweige zu einem Ausgangssignal der ersten Stufe zusammenfassen, und wobei die Combiner der zweiten Stufe jeweils zumindest zwei Ausgangssignale der ersten Stufe zu einem Ausgangssignal der zweiten Stufe zusammenfassen.

Ein Verstärkermodul eines erfindungsgemäßen Verstärkers umfasst beispielsweise zumindest vier Verstärkerzweige und zumindest zwei Stufen von Combinern.

Das Eingangssignal der dritten erfindungsgemäße Vorrichtung (und auch der ersten und zweiten erfindungsgemäßen Vorrichtung) kann beispielsweise durch einen Signal-Teiler (Splitter) auf mehrere Verstärkerzweige aufgeteilt werden. Beispiele für einen solchen Splitter sind ein Wilkinson-Splitter und ein Hybrid-Splitter, insbesondere ein 90°-Hybrid-Splitter. Zum Beispiel kann die dritte erfindungsgemäße Vorrichtung (und auch die erste und zweite erfindungsgemäße Vorrichtung) mehrere Stufen von solchen Splittern umfassen, bevorzugt zumindest zwei Stufen von Splittern, besonders bevorzugt zumindest drei Stufen von Splittern. Insbesondere kann die Anzahl der Stufen von Splittern (bzw. die Anzahl der Splitter) der Anzahl der Stufen von Combinern (bzw. der Anzahl der Combiner) entsprechen.

Ein Verstärkermodul eines erfindungsgemäßen Verstärkers umfasst beispielsweise zumindest zwei Stufen von Splittern, vier Verstärkerzweige und zwei Stufen von Combinern.

Gemäß einem Ausführungsbeispiel der dritten erfindungsgemäßen Vorrichtung sind die Schutzfilter zwischen die erste Stufe von Signal-Kombinieren und den Ausgang geschaltet. Dadurch kann die Anzahl der benötigten Schutzfilter reduziert werden.

Zum Beispiel können die Schutzfilter zwischen die erste Stufe von Signal-Kombinieren und eine zweite Stufe von Signal-Kombinieren geschaltet werden. Um nur ein Schutzfilter für alle Verstärkereinheiten zu benötigen, kann das Schutzfilter beispielsweise zwischen die letzte Stufe von Combinern und den Ausgang geschaltet (d.h. am Ausgang angeordnet) sein.

Gemäß einem Ausführungsbeispiel der dritten erfindungsgemäßen Vorrichtung umfasst die dritte erfindungsgemäße Vorrichtung nur ein Schutzfilter, wobei das Schutzfilter am Verstärkerausgang angeordnet ist.

Gemäß einem Ausführungsbeispiel der dritten erfindungsgemäßen Vorrichtung umfasst jeder Verstärkerzweig ferner eines der Schutzfilter. Dies ist beispielsweise vorteilhaft, um die Belastung der einzelnen Schutzfilter möglichst gering zu halten.

Eine Verwendung ist die Verwendung eines oder mehrerer Schutzfilter in einem Verstärker für einen Teilchenbeschleuniger zum Schutz der Verstärkereinheiten des Verstärkers vor vom Beschleunigungsresonator ausgehenden und in den Verstärkerausgang des Verstärkers laufenden Störsignalen. Zum Beispiel sind die Schutzfilter zwischen die Verstärkereinheiten und den Ausgang des Verstärkers bzw. den Beschleunigungsresonator geschaltet. Die Schutzfilter sind beispielsweise Hochpassfilter und/oder Bandpassfilter. Die Grenzfrequenz eines als Hochpassfilter gebildeten Schutzfilters beträgt, wie oben ausgeführt, beispielsweise 50%, vorzugsweise 75%, besonders vorzugsweise 90% der Grundfrequenz der Grundwelle. Die untere Grenzfrequenz eines als Bandpassfilter gebildeten Schutzfilters beträgt beispielsweise 50%, vorzugsweise 75%, besonders vorzugsweise 90% der Grundfrequenz der Grundwelle. Die obere Grenzfrequenz eines als Bandpassfilter gebildeten Schutzfilters beträgt beispielsweise 150%, vorzugsweise 125%, besonders vorzugsweise 110% der Grundfrequenz der Grundwelle. Der Verstärker entspricht zum Beispiel einer der erfindungsgemäßen Vorrichtungen. Die Verwendung der Schutzfilter dient
dabei unter anderem zur Dämpfung von in den Ausgang des Verstärkers laufenden (niederfrequenten und/oder höherfrequenten) Störsignalanteilen eines Störsignals von dem Beschleunigungsresonators des Teilchenbeschleunigers (z.B. eines Störsignals mit Spannungsamplituden größer als oder gleich 130 V, insbesondere mit Spannungsamplituden größer als oder gleich 150 V).

Eine weitere Verwendung ist die Verwendung eines oder mehrerer Signal-Kombinierer in einem Verstärker für einen Teilchenbeschleuniger zum Schutz der Verstärkereinheiten des Verstärkers vor vom Beschleunigungsresonator ausgehenden und in den Verstärkerausgang des Verstärkers laufenden Störsignalen. Zum Beispiel sind die einen oder mehreren Signal-Kombinierer zwischen die Verstärkereinheiten und den Ausgang des Verstärkers bzw. den Beschleunigungsresonator geschaltet. Der Verstärker entspricht zum Beispiel einer der erfindungsgemäßen Vorrichtungen. Die Verwendung der Signal-Kombinierer dient dabei unter anderem zur Dämpfung von in den Ausgang des Verstärkers laufenden (niederfrequenten und/oder höherfrequenten) Störsignalanteilen eines Störsignals von dem Beschleunigungsresonators des Teilchenbeschleunigers (z.B. eines Störsignals mit Spannungsamplituden größer als oder gleich 130 V, insbesondere mit Spannungsamplituden größer als oder gleich 150 V).

Die erfindungsgemäße Verwendung ist die Verwendung einer oder mehrerer erfindungsgemäßer Schaltungsanordnungen in einem Verstärker für einen Teilchenbeschleuniger zum Schutz der Verstärkereinheiten des Verstärkers vor vom Beschleunigungsresonator ausgehenden und in den Verstärkerausgang des Verstärkers laufenden Störsignalen. Zum Beispiel sind die einen oder mehreren erfindungsgemäßen Schaltungsanordnungen zwischen die Verstärkereinheiten und den Ausgang des Verstärkers bzw. den Beschleunigungsresonator geschaltet. Der Verstärker entspricht zum Beispiel einer der erfindungsgemäßen Vorrichtungen. Die Verwendung der erfindungsgemäßen Schaltungsanordnung dient dabei unter anderem zur Dämpfung von in den Ausgang des Verstärkers laufenden (niederfrequenten und/oder höherfrequenten) Störsignalanteilen eines Störsignals von dem Beschleunigungsresonators des Teilchenbeschleunigers (z.B. eines Störsignals mit Spannungsamplituden größer als oder gleich 130 V, insbesondere mit Spannungsamplituden größer als oder gleich 150 V). Außerdem dient die Verwendung der erfindungsgemäße Schaltungsanordnung zur Vermeidung einer Reflexion der Oberwellen des Ausgangssignals der Verstärkereinheit zurück auf die Verstärkereinheit.

Die in dieser Anmeldung beschriebenen beispielhaften Ausführungsbeispiele der vorliegenden Erfindung sollen auch in allen Kombinationen miteinander offenbart sein.

Weitere vorteilhafte beispielhafte Ausgestaltungen der Erfindung sind der folgenden detaillierten Beschreibung einiger beispielhafter Ausführungsformen der vorliegenden Erfindung, insbesondere in Verbindung mit den Figuren zu entnehmen.

Die der Anmeldung beiliegenden Figuren sollen jedoch nur dem Zwecke der Verdeutlichung, nicht aber zur Bestimmung des Schutzbereiches der Erfindung dienen. Die beiliegenden Zeichnungen sind nicht maßstabsgetreu und sollen lediglich das allgemeine Konzept der vorliegenden Erfindung beispielhaft widerspiegeln. Insbesondere sollen Merkmale, die in den Figuren enthalten sind, keineswegs als notwendiger Bestandteil der vorliegenden Erfindung erachtet werden.

### Kurze Beschreibung der Zeichnungen

In den Figuren zeigen
- Fig. 1:: ein Blockschaltbild eines Beispiels für ein erfindungsgemäßes System mit einem HF-Verstärker und einem Teilchenbeschleuniger;
- Fig. 2a:: eine schematische Darstellung eines Beispiels für ein erfindungsgemäßes Verstärkermodul eines HF-Verstärkers;
- Fig. 2b:: eine schematische Darstellung eines Beispiels für ein erfindungsgemäßes Verstärkermodul eines HF-Verstärkers;
- Fig. 2c:: eine schematische Darstellung eines Beispiels für ein erfindungsgemäßes Verstärkermodul eines HF-Verstärkers;
- Fig. 2d:: eine schematische Darstellung eines Beispiels für ein erfindungsgemäßes Verstärkermodul eines HF-Verstärkers;
- Fig. 2e:: eine schematische Darstellung eines Beispiels für einen erfindungsgemäßen Verstärkerzweig eines HF-Verstärkers;
- Fig. 2f:: eine schematische Darstellung eines Beispiels für einen erfindungsgemäßen Verstärkerzweig eines HF-Verstärkers;
- Fig. 3:: ein Schaltschema eines klassischen Diplexers;
- Fig. 4:: ein Schaltschema eines Beispiels für eine erfindungsgemäße Schaltungsanordnung bzw. einen Bidiplexer; und
- Fig. 5: zwei Frequenzgänge des Beispiels für eine erfindungsgemäße Schaltungsanordnung bzw. einen Bidiplexer aus Fig. 4.

### Detaillierte Beschreibung einiger beispielhafter Ausführungsformen der vorliegenden Erfindung

Im Folgenden werden Komponenten einer beispielhaften Ausführungsform eines erfindungsgemäßen VHF-Verstärkers gemäß dem ersten Aspekt der Erfindung, der in diesem Abschnitt stets als Verstärker CRE312B bezeichnet wird, erläutert. Jeder Verstärkerzweig dieses Verstärkers verfügt über eine erfindungsgemäße Schaltungsanordnung, die im Folgenden stets als bidirektionaler Diplexer oder als Bidiplexer bezeichnet wird und in den Figuren mit dem Bezugszeichen 100 gekennzeichnet ist. Der Verstärker CRE312B ist für den Betrieb bei 72 MHz und für die Hochfrequenzversorgung eines Beschleunigungsresonators eines Teilchenbeschleunigers optimiert. Grundsätzlich ist die vorliegende Erfindung jedoch nicht auf eine Anwendung bei dieser speziellen Frequenz und in diesem Einsatzfeld beschränkt, sondern ist im gesamten HF-Bereich (ca. 30 MHz bis ca. 30 GHz), insbesondere im Frequenzbereich unterhalb von 100 MHz anwendbar. Ein weiteres denkbares Einsatzfeld der Erfindung sind beispielsweise Funk- und Fernsehsendeanlagen.

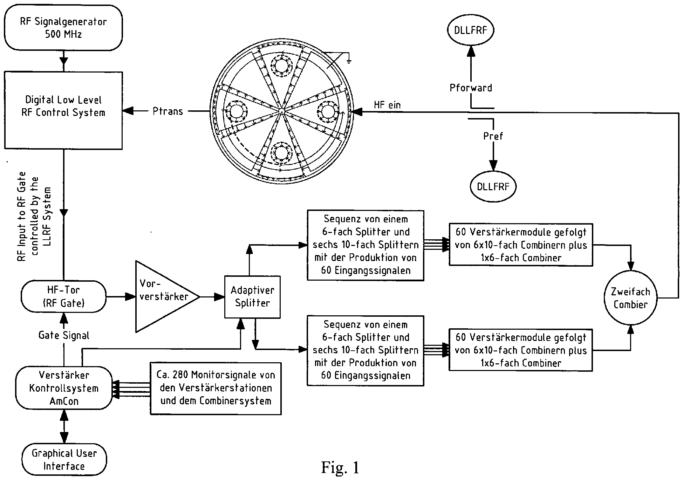

Fig. 1 zeigt ein Blockschaltbild des Verstärkers CRE312B. Das Eingangssignal des VHF-Verstärkers wird im Betrieb eines Teilchenbeschleunigers von einem Signalgenerator geliefert, das durch die als Digital Low Level RF (DLLRF) Control System bezeichnete Kontroll- und Regelelektronik moduliert wird. Die DLLRF Kontrollelektronik überwacht die Phase und Amplitude des Beschleunigungsfeldes im Beschleunigungsresonator des Teilchenbeschleunigers. Für den Verstärker CRE 312B ist dies der Beschleunigungsresonator eines 250 MeV Protonenzyklotrons mit Sektorfokussierung und einer Betriebsfrequenz von 72 MHz. Die Höhe des Verstärkereingangssignals beträgt 0 dBm (1 mW). Der Weg dieses Signals und seine Verstärkung auf maximal 150 kW ist in Fig. 1 skizziert.

Das Signal der DLLRF Kontrollelektronik erreicht zunächst das Hochfrequenztor (HF Tor bzw. RF Gate), es ist das erste Element der Eingangsstufe des Verstärkers. Das Öffnen und Schließen des HF Tores wird vom Kontrollsystem AmCon gesteuert. Das RF Gate bietet die zeitlich schnellste Möglichkeit, das Ausgangssignal des Verstärkers CRE312B zu löschen und damit z.B. den Strahl des Teilchenbeschleunigers auszuschalten.

Das Verstärkerkontrollsystem AmCon registriert eine große Zahl von charakteristischen Messwerten, welche von den Baugruppen des Verstärkers CRE312B geliefert werden und überwacht und regelt die Funktionen des Verstärkers CRE312B.

Nach dem Passieren des HF Tores wird das Eingangssignal zur Weiterverarbeitung in einem rauscharmen Eingangsverstärker auf das für die nachfolgenden elektronischen Kreise notwendige Niveau verstärkt. Das Eingangssignal erreicht dann die ersten Verstärkerbaugruppen des Verstärkers CRE312B. Eine Verstärkerbaugruppe ist definiert durch einen Splitter am Eingang und einem korrespondierenden Combiner am Ausgang der Baugruppe.

Signal-Teiler (Splitter) und Signal-Kombinierer (Combiner) sind notwendige Baugruppen in einem transistorisierten VHF-Hochleistungsverstärker. Die leistungsfähigsten Transistoren für den VHF- Bereich liefern je nach Typ Ausgangsleistungen zwischen 400 und 800 Watt. Berücksichtigt man Verluste im Combiner-Netzwerk, können bis zu 500 Transistoren in einem Hochleistungsverstärker enthalten sein. Im Verstärker CRE 312B, der mit dem Transistor BLF 574 der Firma NXP bestückt ist, sind es 480 Transistoren. Das Eingangssignal des Verstärkers CRE312B muss also in mehreren Stufen insgesamt 480-mal geteilt werden. Umgekehrt müssen die 480 Ausgangssignale der Leistungstransistoren in mehreren Combiner-Stufen 480-mal kombiniert werden. Dies geschieht zweckmäßigerweise so, dass einer Combiner-Stufe mit einem Nc-fachen Combiner eine Splitter-Stufe mit einem Nc-fachen Splitter entspricht.

Der Verstärker CRE312B ist insgesamt aus den folgenden Verstärkerbaugruppen aufgebaut:
- Verstärkerabteilungen (Amplifier Divisions), die aus Verstärkersektionen zusammengesetzt sind,
- Verstärkersektionen, die aus Verstärkermodulen zusammengesetzt sind,
- Verstärkermodule, die aus zwei symmetrischen Halbleiterverstärkern bzw. vier Verstärkerzweigen zusammengesetzt sind,
- symmetrische Halbleiterverstärker, die aus zwei Leistungstransistoren bzw. zwei Verstärkerzweigen zusammengesetzt sind.

Der Verstärker CRE312B umfasst 6 Stationen, in welchen die Verstärkerbaugruppen untergebracht sind. Die Stationen bestehen jeweils aus einer oberen und einer unteren Verstärkersektion. Diese sind vorzugsweise oben bzw. unten in einem Standard 19"-Elektronikschrank montiert.

Die Verstärkerabteilung #1 (vgl. Fig. 1) des Verstärkers CRE312B besteht aus den oberen Verstärkersektionen der 6 Verstärkerstationen und die Verstärkerabteilung #2 (vgl. Fig. 1) aus den unteren 6 Verstärkersektionen der Verstärkerstationen. Jede Sektion besteht aus 10 Verstärkermodulen.

Das Verstärkermodul ist das zentrale elektronische Bauelement des Verstärkers CRE312B. Die Ausgangssignale der 10 Verstärkermodule einer Verstärkersektion werden in einem Zehnfachcombiner in koaxialem Rohrleitungsdesign zu einem Gesamtsignal einer Verstärkersektion addiert. Weitere Combiner von immer größerer Leistungstragfähigkeit führen die Signale aus den insgesamt 12 Zehnfachcombinern zusammen.

Das Verstärkermodul im Verstärker CRE312B ist aus den folgenden Elementen aufgebaut:
- einem Zweifach-Splitter am Eingang des Verstärkermoduls,
- zwei symmetrischen Verstärkern (jeweils umfassend einen Zweifach-Splitter, zwei Verstärkerzweige und einen Zweifach-Combiner),
- einem Zweifach-Combiner,
- einem bidirektionalen HF-Leistungskoppler am Ausgang des Verstärkermoduls.

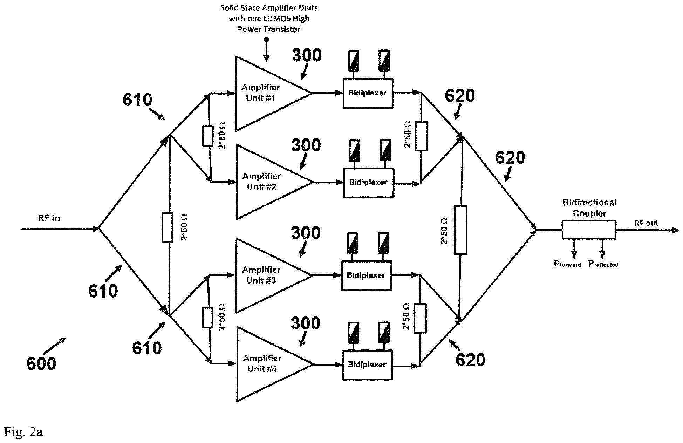

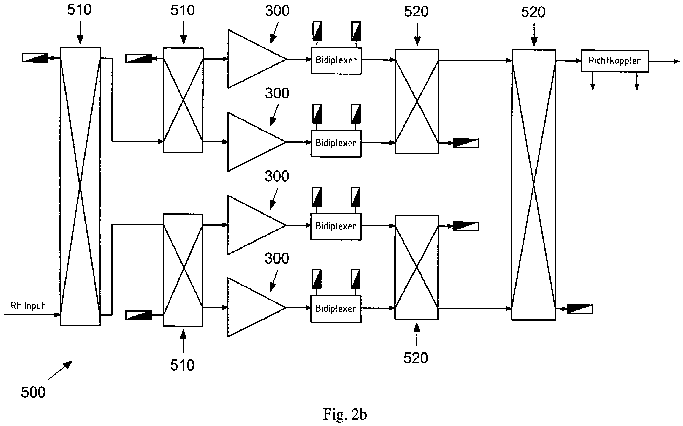

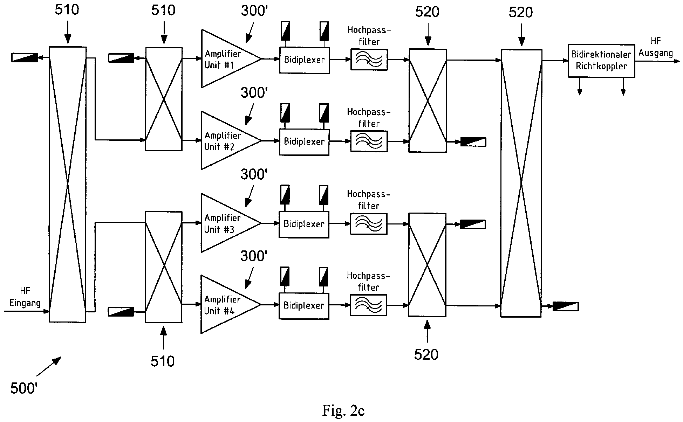

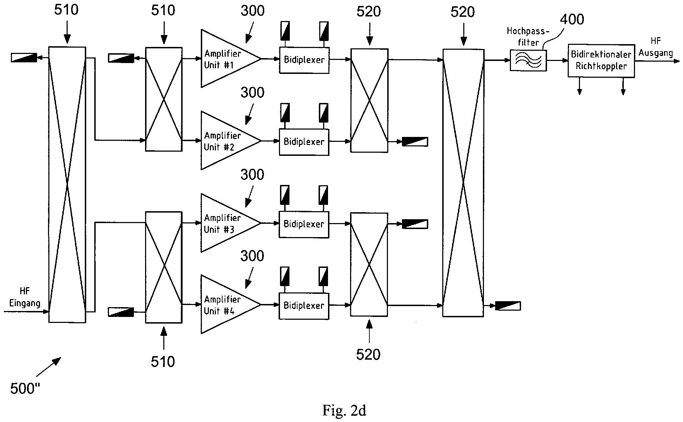

Fig. 2a, Fig. 2b, Fig. 2c und Fig. 2d zeigen schematisch Beispiele für ein Verstärkermodul im Verstärker CRE312B.

Das Verstärkermodul 600 aus Fig. 2a umfasst zwei Stufen von Wilkinson-Splittern 610, vier Verstärkerzweige 300 und zwei Stufen von Wilkinson-Combinern 620.

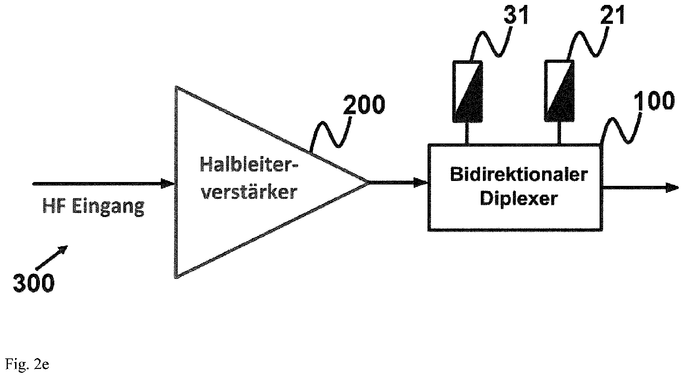

Das Verstärkermodul 500 aus Fig. 2b umfasst zwei Stufen von Hybrid-Splittern 510, vier Verstärkerzweige 300 (s. Fig. 2e) und zwei Stufen von Hybrid-Combinern 520. Die Verstärkermodule 500' aus Fig. 2c und 500" aus Fig. 2d stellen Varianten des Verstärkermoduls 500 mit einem oder mehreren Hochpassfiltern 400 als Schutzfilter dar.

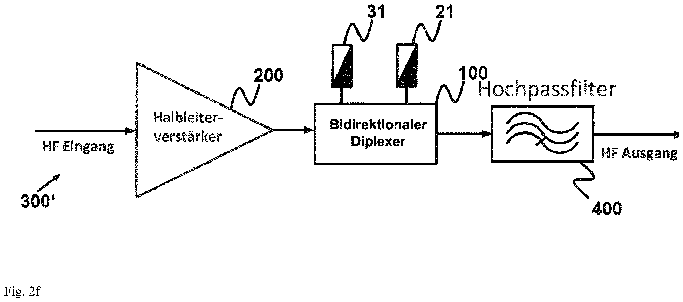

Das Verstärkermodul 500' aus Fig. 2c umfasst ebenfalls zwei Stufen von Hybrid-Splittern 510 und zwei Stufen von Hybrid-Combinern 520. Außerdem umfasst das Verstärkermodul 500' vier modifizierte Verstärkerzweige 300' (s. Fig. 2f), in denen jeweils ein Hochpassfilter 400 als Schutzfilter am Ausgang des Verstärkerzweigs angeordnet ist.

Das Verstärkermodul 500" aus Fig. 2d umfasst ebenfalls zwei Stufen von Hybrid-Splittern 510 und zwei Stufen von Hybrid-Combinern 520 sowie vier Verstärkerzweige 300. Beim Verstärkermodul 500" ist das Hochpassfilter 400 als Schutzfilter zwischen die letzte Stufe der Hybrid-Combiner 520 und den Ausgang des Verstärkermoduls 500" geschaltet.

Die Grenzfrequenz des Hochpassfilters 400 liegt dabei unterhalb der Fundamentalfrequenz des Verstärkers CRE312B von 72Mhz. Das Hochpassfilter 400 ist hier beispielhaft ein Filter erster Ordnung und wird durch zwei Kondensatoren (C=47,5 pF) und eine Spule (L=107 nH) in T-Schaltung gebildet, so dass die Grenzfrequenz des Hochpassfilters 400 ca. 65 MHz beträgt. Ein solches Hochpassfilter erster Ordnung weist eine Dämpfung von ca. -6 dB bei 40 MHz, ca. -14 dB bei 30 MHz, ca. -25 dB bei 20 MHz, ca. -44 dB bei 10 MHz und ca. -62 dB bei 5 MHz auf.

Sowohl beim Verstärkermodul 500' als auch beim Verstärkermodul 500" dämpft das Hochpassfilter demnach (niederfrequente) Störsignalanteile eines vom Ausgang des Verstärkermoduls (bzw. vom Verstärkerausgang des Verstärkers CRE312B) in Richtung der Verstärkereinheiten bzw. der Halbleiterverstärkereinheiten 200 laufenden Störsignals mit Frequenzen unterhalb der Grenzfrequenz von 65 MHz.

90°-Hybrid-Combiner haben eine hervorragende Anpassung (engl. matching) des gemeinsamen Ausgangstors (engl. common port) sowohl im Fall der Abstimmung der individuellen Halbleiterverstärkereinheiten bzw. Verstärkerzweige auf maximale Ausgangsleistung, auf maximalen Wirkungsgrad als auch auf maximale Verstärkung. Außerdem haben 90°-Hybrid-Combiner eine sehr geringe Reduzierung der Isolation zwischen den einzelnen Halbleiterverstärkern bzw. Verstärkerzweigen im Falle einer schlecht angepassten Last am Ausgangstor (engl. mismatched common Port) sowie eine größere Robustheit (engl. immunity) der Halbleiterverstärkereinheiten bzw. Verstärkerzweige durch ihre Kombination in einem 90°-Hybrid-Combiner als im Fall eines alleinstehenden Halbleiterverstärkers bzw. Verstärkerzweigs. 90°-Hybrid-Combiner sind schmalbandiger als Wilkinson-Combiner.

Wilkinson-Combiner, deren Ausgangstor auf eine 50 Ω Last angepasst ist, fordern eine Anpassung der zu kombinierenden Halbleiterverstärkereinheiten bzw. Verstärkerzweige auf 50 Ω, andernfalls ist eine Kombination nach Wilkinson ineffektiv. Eine Veränderung der Anpassung geschieht aber, falls die Halbleiterverstärkereinheiten bzw. Verstärkerzweige in unterschiedlichen Betriebszuständen betrieben werden. Außerdem kann es bei Wilkinson-Combinern zu einer Reduzierung der Isolation zwischen den Eingangstoren kommen, falls es zu einer Fehlanpassung des Ausgangstors kommt. Ein Vorteil der Wilkinson Combiner liegt in dem symmetrischen Aufbau und in der Einfachheit des Designs.

Fig. 2e zeigt schematisch einen Verstärkerzweig 300 des Verstärkermoduls 600, 500 und 500". Der Verstärkerzweig 300 umfasst zumindest zwei Elemente: die Verstärkereinheit bzw. die Halbleiterverstärkereinheit 200 im Design einer Gegentaktendstufe mit dem LDMOS Transistor BLF 574 und den bidirektionalen Diplexer 100 mit den zwei Lastwiderständen 21 und 31. Für den Aufbau und die Eigenschaften des Transistors BLF 574 von NXP wird ausdrücklich auf das Datenblatt "BLF574, HF / VHF power LDMOS transistor, Rev. 02 - 24 February 2009, Product data sheet" verwiesen, das derzeit unter der URL "http://www.nxp.com/documents/data_sheet/BLF574.pdf" verfügbar ist.

Der bidirektionale Diplexer 100 ist eine Weiterentwicklung des klassischen Diplexers, insbesondere für die spezielle Anwendung in einem Halbleiterverstärker für die HF-Versorgung eines Beschleunigungsresonators.

Fig. 2f zeigt schematisch einen modifizierten Verstärkerzweig 300' des Verstärkermoduls 500'. Der modifizierte Verstärkerzweig 300' umfasst neben der Verstärkereinheit bzw. der Halbleiterverstärkereinheit 200 den bidirektionalen Diplexer 100 mit den zwei Lastwiderständen 21 und 31 sowie das Hochpassfilter 400 als Schutzfilter. Das Hochpassfilter 400 ist zwischen den Bidiplexer 100 und den Ausgang des Verstärkerzweigs geschaltet.

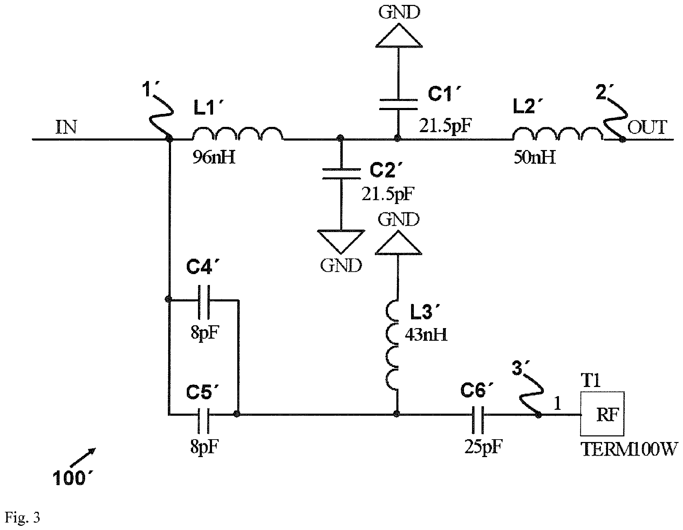

Der in Fig. 3 gezeigte klassische Diplexer 100' ist ein Multiplexer, der einen Eingang (IN) mit zwei Ausgängen (OUT, RF) verbindet. Der klassische Diplexer 100' ist eine Frequenzweiche und hat die Aufgabe, zwei Frequenzbereiche voneinander zu entkoppeln. Dafür verfügt der klassische Diplexer 100' über ein Hochpassfilter und ein Tiefpassfilter. Das Tiefpassfilter ist zwischen dem Eingangsknoten 1' und dem Ausgangsknoten 2' angeordnet und kann zum Beispiel durch die in Fig. 3 dargestellte Verschaltung der Spulen L1' (L=96 nH) und L2' (L=50 nH) sowie der Kondensatoren C1' (C=21,5 pF) und C2' (C=21,5 pF) realisiert werden. Der Hochpassfilter ist zwischen dem Eingangsknoten 1' und dem Ausgangsknoten 3' angeordnet und kann zum Beispiel durch die in Fig. 3 dargestellte Verschaltung der Spule L3' (L=43 nH) sowie der Kondensatoren C4' (C=8 pF), C5' (C=8 pF) und C6' (C=25 pF) realisiert werden.

Die Fundamentalfrequenz der Halbleiterverstärkereinheit 200 von 72 MHz, also die Grundfrequenz der Grundwelle des Ausgangssignals der Halbleiterverstärkereinheit wird möglichst gering gedämpft vom Eingang des klassischen Diplexers zum Ausgang des Diplexers übertragen, während alle höheren Frequenzen, insbesondere die zweite und dritte Harmonische, einem Lastwiderstand zugeführt werden. In diesem speziellen Diplexer werden also alle HF-Signale mit Frequenzen, die deutlich oberhalb der Fundamentalfrequenz liegen, in einem Lastwiderstand absorbiert.

Der 120 MHz - "Crossover Diplexer" 100' aus Fig. 3 schwächt die Fundamentalfrequenz von 72 MHz um ca. -0.1 dB, die zweite Harmonische 144 MHz um ca. -9.5 dB, und die dritte Harmonische von 216 MHz um ca. -19 dB ab. Das am Diplexer 100' reflektierte Signal liegt im gesamten Frequenzbereich 20 dB unter dem einlaufenden Signal.

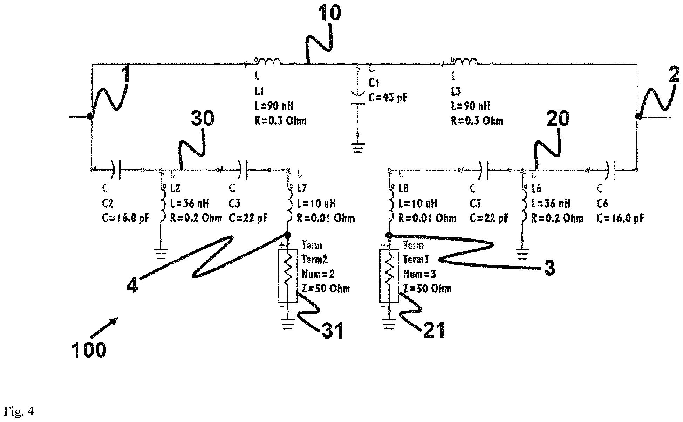

Eine Besonderheit des Verstärkers CRE312B ist der Einsatz des erfindungsgemäßen bidirektionalen Diplexers 100 bzw. Bidiplexers 100 am Ausgang jeder Halbleiterverstärkereinheit zum Schutz der Leistungstransistoren der Halbleiterverstärkereinheit. Das Schaltschema eines Beispiels für einen Bidiplexer 100 ist in Fig. 4 gezeigt. Die dort dargestellten Kenngrößen der Bauteile sind lediglich als beispielhaft zu verstehen.

Der Bidiplexer 100 weist einen ersten Ein- und/oder Ausgangsknoten 1, einen zweiten Ein- und/oder Ausgangsknoten 2, einen dritten Knoten 3 und einen vierten Knoten 4 auf. Der erste Ein- und/oder Ausgangsknoten 1 und der zweite Ein- und/oder Ausgangsknoten 2 sind durch die Durchgangsfilterstrecke 10 elektrisch miteinander verbunden. Der zweite Ein- und/oder Ausgangsknoten 2 und der dritte Knoten 3 sind durch die erste Absorptionsfilterstrecke 20 elektrisch miteinander verbunden. Der erste Ein- und/oder Ausgangsknoten 1 und der vierte Knoten 4 sind durch die zweite Absorptionsfilterstrecke 30 elektrisch miteinander verbunden.

In der Durchgangsfilterstrecke 10 ist ein Durchgangsfilter mit Tiefpasscharakteristik (d.h. ein Tiefpassfilter) gebildet durch die Spulen L1 (z.B. L=90 nH) und L3 (z.B. L=90 nH) sowie den Kondensator C1 (z.B. C=43 pF) angeordnet. Die Spulen L1 und L3 sowie Kondensator C1 sind in einer T-Schaltung angeordnet. In der ersten Absorptionsfilterstrecke 20 ist ein erstes Hochpassfilter gebildet durch die Spulen L6 (z.B. L=36 nH) und L8 (z.B. L=10 nH) sowie den Kondensatoren C5 (z.B. C=22 pF) und C6 (z.B. C=1665 MHz beträgt. Ein solches Hochpassfilter erster Ordnung weist eine Dämpfung von ca. -6 dB bei 40 MHz, ca. -1465 MHz beträgt. Ein solches Hochpassfilter erster Ordnung weist eine Dämpfung von ca. -6 dB bei 40 MHz, ca. -14 dB bei 30 MHz, ca. -25 dB bei 20 MHz, ca. -44 dB bei 10 MHz und ca. -62 dB bei 5 MHz auf. Bei 30 MHz, ca. -25 dB bei 20 MHz, ca. -44 dB bei 10 MHz und ca. -62 dB bei 5 MHz auf.) angeordnet. Die Kondensatoren C5 und C6 sowie die Spule L6 sind in einer T-Schaltung angeordnet, wobei der Kondensator C6 zum zweiten Ein- und/oder Ausgangsknoten 2 und der Kondensator C5 zum dritten Knoten 3 orientiert sind. Die Spule L8 ist zwischen den Kondensator C5 und den dritten Knoten 3 geschaltet. In der zweiten Absorptionsfilterstrecke 30 ist ein zweites Hochpassfilter gebildet durch die Spulen L2 (z.B. L=36 nH) und L7 (z.B. L=10 nH) sowie den Kondensatoren C3 (z.B. C=22 pF) und C2 (z.B. C=16 pF) angeordnet. Die Verschaltung der Spulen L2 und L7 sowie der Kondensatoren C3 und C2 des zweiten Hochpassfilters entspricht der oben erläuterten Verschaltung der Spulen L6 und L8 sowie der Kondensatoren C5 und C6 des ersten Hochpassfilters.

Die erste Absorptionsfilterstrecke 20 ist mit dem Lastwiderstand 21 (z.B. R=50 Ω), der am dritten Knoten 3 angeordnet ist, abgeschlossen. Die zweite Absorptionsfilterstrecke 30 ist mit dem Lastwiderstand 31 (z.B. R=50 Ω), der am vierten Knoten 4 angeordnet ist, abgeschlossen.

Der bidirektionale Diplexer 100 aus Fig. 4 wirkt für HF-Signale, die von der Halbleiterverstärkereinheit aus einfallen, genauso wie für HF-Signale, die vom Resonator des Zyklotrons kommen.

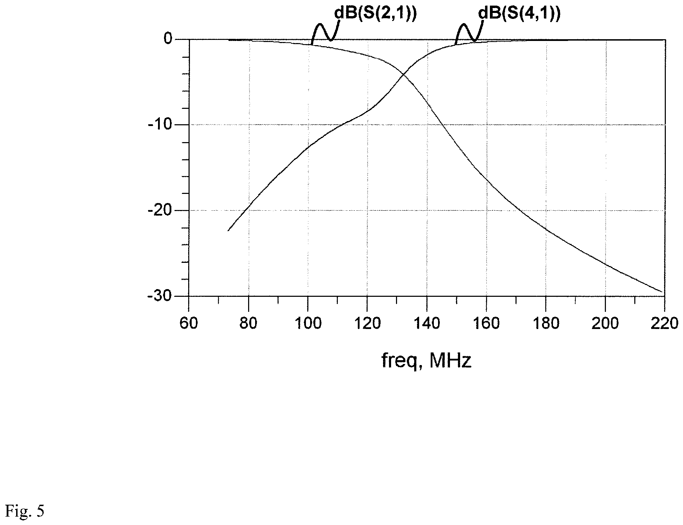

Der "bidirektionale 130 MHz - Crossover Bidiplexer" aus Fig. 4, also der Bidiplexer 100, schwächt die Fundamentalfrequenz von 72 MHz um ca. -0.15 dB, die zweite Harmonische 144 MHz um ca. -10.5 dB, und die dritte Harmonische von 216 MHz um ca. -25 dB ab. Diese Dämpfungscharakteristik des Bidiplexers 100 für ein vom ersten Ein- und/oder Ausgangsknoten 1 zum zweiten Ein- und/oder Ausgangsknoten 2 übertragenes Signal (d.h. ein entlang der Durchgangsfilterstrecke 10 übertragenes Signal) kann auch dem Frequenzgang dB(S(2,1)) in Fig. 5 entnommen werden. Die Dämpfungscharakteristik des Bidiplexers 100 für ein vom ersten Ein- und/oder Ausgangsknoten 1 zum vierten Knoten 4 übertragenes Signal (d.h. ein entlang der Absorptionsfilterstrecke 30 übertragenes Signal) kann dem Frequenzgang dB(S(4,1)) in Fig. 5 entnommen werden. Das am Bidiplexer 100 reflektierte Signal liegt im gesamten Frequenzbereich 20 dB unter dem einlaufenden Signal.

Der Bedeutung des Bidiplexers 100 für den Schutz des Leistungstransistors in der Verstärkereinheit bzw. der Halbleiterverstärkereinheit 200 besteht in zweifacher Weise: durch die Vermeidung von reflektierten Oberwellen und durch die Absorption von hochfrequenten Emissionen des Beschleunigungsresonators.

Das Ausgangssignal der Gegentaktendstufe (also der Halbleiterverstärkereinheit 200) ist nicht frei von Oberwellen. Die in diesen Oberwellen enthaltene Leistung ist nutzlos und wird im Bidiplexer 100 zumindest im Wesentlichen von der Grundwelle getrennt und in einem Abschlusswiderstand absorbiert. Diese Leistung kann daher auch nicht auf den Leistungstransistor reflektiert werden, wodurch eine schädliche, zusätzliche Erwärmung des Sperrbezirks (Junction) des Transistors vermieden wird.

Wie im obigen Abschnitt "Hintergrund der Erfindung" ausführlich beschrieben, können im Beschleunigungsresonator durch freie Elektronenströme und (Electron) insbesondere durch plötzliche Gasentladungen und Störlichtbögen, Störsignale mit hoher Spannungsamplitude (z.B. Störsignale mit Spannungsamplituden größer als oder gleich 130 V, insbesondere mit Spannungsamplituden größer als oder gleich 150 V) entstehen.

Die durch diesen unerwünschten Betriebszustand erzeugte Gefahr für den Verstärker CRE312B wird durch den Einsatz des Bidiplexers 100 reduziert. Der Bidiplexer 100 wirkt als Leistungsteiler für die Störsignale, die vom Beschleunigungsresonator herrühren. Der Einfluss des bidirektionalen Kopplers ist umso effektiver, je höher die Frequenz des Resonator-Signals über der Fundamentalfrequenz der Halbleiterverstärkereinheit liegt. Der Vorteil des Bidiplexers 100 liegt unter anderem darin, dass sowohl die vom Verstärker erzeugten höheren Harmonischen (d.h. insbesondere Störsignalanteile mit einer Frequenz oberhalb der Grenzfrequenz des Durchgangsfilters) als auch diejenigen eines vom Beschleunigungsresonator abgegebenen Störsignals gedämpft werden. Dadurch kann ein Schutz der Leistungstransistoren der Halbleiterverstärkereinheiten 200 vor diesen Störsignalanteilen gewährleistet werden.

Der Bidiplexer 100 eignet sich daher besonders vorteilhaft zum Einsatz in einem VHF-Verstärker wie dem Verstärker CRE312B.

Neben den unerwünschten höherfrequenten Störsignalen kann es, wie oben erläutert, aber auch zur Erzeugung von niederfrequenten Störsignalen im Beschleunigungsresonator kommen, die ebenfalls zur Zerstörung der Leistungstransistoren der Verstärkereinheiten führen können. Zusätzlich zum Bidiplexer 100 kann daher im Verstärker CRE312B auch ein (vgl. Verstärkermodul 500") oder mehrere (vgl. Verstärkermodul 500') Hochpassfilter 400 (und/oder ein oder mehrere Bandpassfilter) als Schutzfilter eingesetzt werden. Der Vorteil der Hochpassfilter 400 liegt unter anderem darin, dass die niederfrequenten Störsignalanteile (d.h. insbesondere Störsignalanteile mit einer Frequenz unterhalb der Grenzfrequenz von 65 MHz) eines vom Beschleunigungsresonator abgegebenen Störsignals gedämpft werden. Dadurch kann ein zusätzlicher Schutz der Leistungstransistoren der Halbleiterverstärkereinheiten 200 vor diesen Störsignalanteilen gewährleistet werden.

Alternativ oder zusätzlich können die Leistungstransistoren der Verstärkereinheiten durch die Verwendung von 90°-Hybrid-Combinern, die schmalbandiger als Wilkinson-Combiner sind, vor vom Beschleunigungsresonator ausgehenden Störsignalen geschützt werden.

Es ist somit möglich, in dem Verstärker CRE312B verschiedene Schutzebenen zum Schutz der Leistungstransistoren der Halbleiterverstärkereinheiten 200 vor Störsignalen vorzusehen. Das Verstärkermodul 500' aus Fig. 2c umfasst zum Beispiel vier solcher Schutzebenen, nämlich den Bidiplexer 100 (1. Schutzebene), das Hochpassfilter 400 (2. Schutzebene), die 90°-Hybrid-Combiner der ersten Stufe (3.Schutzebene) und den 90°-Hybrid-Combiner der zweiten Stufe (4.Schutzebene).

In einer besonders einfachen Ausführungsform des Verstärkers CRE312B ist es grundsätzlich auch denkbar, dass auf den Bidiplexer 100 und das Hochpassfilter 400 vollständig verzichtet wird, wenn 90°-Hybrid-Combiner als Signal-Kombinierer eingesetzt werden. Eine solche einfache Ausführungsform würde nur durch die schmalbandige Übertragungsfunktion der 90°-Hybrid-Combiner einen Schutz der Leistungstransistoren der Halbleiterverstärkereinheiten 200 vor Störsignalanteile eines vom Beschleunigungsresonator abgegebenen Störsignals gewährleisten.

In einer anderen einfachen Ausführungsform des Verstärkers CRE312B ist es grundsätzlich auch denkbar, dass auf den Bidiplexer 100 (vgl. Fig. 2f) vollständig verzichtet wird und lediglich das Hochpassfilter 400 als Schutzfilter verwendet wird. Dabei kann das Hochpassfilter 400 zum Beispiel in einem oder mehreren (z.B. in allen) Verstärkerzweigen und/oder hinter einer Stufe von Combiner (beispielsweise hinter der letzten stufe von Combinern) angeordnet sein. Eine solche einfache Ausführungsform würde nur einen Schutz der Leistungstransistoren der Halbleiterverstärkereinheiten 200 vor niederfrequenten Störsignalanteile eines vom Beschleunigungsresonator abgegebenen Störsignals gewährleisten. Da unter Umständen die niederfrequenten Störsignalanteile überwiegen können, kann durch diese besonders einfache Ausführungsform ein ausreichender Schutz bewirkt werden.

In einer anderen einfachen Ausführungsform des Verstärkers CRE312B ist es grundsätzlich denkbar, dass statt dem Bidiplexer 100 der Diplexer 100' zusammen mit dem Hochpassfilter 400 zum Schutz der Leistungstransistoren der Halbleiterverstärkereinheiten 200 verwendet wird. Eine solche einfache Ausführungsform würde einen Schutz der Leistungstransistoren der Halbleiterverstärkereinheiten 200 vor niederfrequenten Störsignalanteilen eines vom Beschleunigungsresonators abgegebenen Störsignals gewährleisten und vor reflektierten Oberwellen des Ausgangssignals der Halbleiterverstärkereinheiten 200.

Die Erfindung wurde anhand von beispielhaften Ausführungsformen und Ausführungsbeispiele beschrieben. Einzelne Merkmale dieser Ausführungsformen und Ausführungsbeispiele sollen aber, soweit nicht explizit hervorgehoben, nicht als wesentlich für die Erfindung angesehen werden. Die vorliegende Erfindung ist nicht auf den konkreten Halbleiterverstärker CRE 312B und/oder den Transistor BLF574 beschränkt; sie ist gleichermaßen anwendbar in jeglichem transistorbasierten Halbleiterverstärker.

## Patentansprüche

1. System, umfassend:
- eine Vorrichtung, insbesondere ein VHF-Verstärker oder ein Verstärkermodul für einen VHF-Verstärker, umfassend einen oder mehrere Verstärkerzweige (300, 300'), und
- einen Teilchenbeschleuniger,
wobei ein Beschleunigungsresonator des Teilchenbeschleunigers mit einem Ausgang der Vorrichtung verbunden ist, wobei jeder Verstärkerzweig (300, 300') der Vorrichtung eine Verstärkereinheit (200) und eine am Ausgang der Verstärkereinheit angeordnete Schaltungsanordnung (100) umfasst, und wobei die Schaltungsanordnung (100) Folgendes umfasst:
- eine Durchgangsfilterstrecke (10) zwischen einem ersten Ein- und/oder Ausgangsknoten (1) und einem zweiten Ein- und/oder Ausgangsknoten (2), wobei in der Durchgangsfilterstrecke (10) ein Durchgangsfilter mit einer Tiefpasscharakteristik angeordnet ist,
- eine erste Absorptionsfilterstrecke (20) zwischen dem zweiten Ein- und/oder Ausgangsknoten (2) und einem dritten Knoten (3), wobei in der ersten Absorptionsfilterstrecke (20) ein erstes Hochpassfilter angeordnet ist, und wobei an dem dritten Knoten (3) ein erster Lastwiderstand (21) angeordnet ist, und
- eine zweite Absorptionsfilterstrecke (30) zwischen dem ersten Ein- und/oder Ausgangsknoten (1) und einem vierten Knoten (4), wobei in der zweiten Absorptionsfilterstrecke (30) ein zweites Hochpassfilter angeordnet ist, und wobei an dem vierten Knoten (4) ein zweiter Lastwiderstand (31) angeordnet ist.

2. System nach Anspruch 1, wobei das Durchgangsfilter und/oder das erste Hochpassfilter und/oder das zweite Hochpassfilter Filter zweiter oder höherer Ordnung sind.

3. System nach einem der Ansprüche 1 und 2, wobei das Durchgangsfilter und/oder das erste Hochpassfilter und/oder das zweite Hochpassfilter passive Filter sind.

4. System nach einem der Ansprüche 1 bis 3, wobei das Durchgangsfilter durch mindestens zwei Spulen (L1, L3) und mindestens einen Kondensator (C1) in T-Schaltung gebildet wird, und/oder wobei das erste und das zweite Hochpassfilter jeweils durch mindestens zwei Kondensatoren (C2, C3; C5, C6) und mindestens eine Spule (L2; L6) in T-Schaltung gebildet werden.

5. System nach einem der Ansprüche 1 bis 4, wobei der erste und zweite Lastwiderstand (21, 31) jeweils dem Leitungswellenwiderstand entsprechen.

6. System nach einem der Ansprüche 1 bis 5, wobei die Vorrichtung mehrere Verstärkerzweige umfasst.

7. System nach einem der Ansprüche 1 bis 6, wobei der erste oder der zweite Ein- und/oder Ausgangsknoten (1,2) der Schaltungsanordnung (100) mit dem Ausgang der Verstärkereinheit (200) verbunden ist.

8. System nach einem der Ansprüche 1 bis 7, wobei jeweils die Ausgangssignale zweier oder mehrerer Verstärkerzweige (300, 300') der ein oder mehreren Verstärkerzweige durch einen Signal-Kombinierer (520, 620), insbesondere einen 90°-Hybrid-Combiner, zu einem Signal zusammengefasst werden.

9. System nach einem der Ansprüche 1 bis 8, wobei die Vorrichtung ferner Folgendes umfasst:
- einen Ausgang, und
- ein oder mehrere Schutzfilter, wobei die Schutzfilter zwischen die Verstärkereinheiten der Verstärkerzweige und den Ausgang geschaltet sind.

10. System nach Anspruch 9, wobei die Vorrichtung ferner Folgendes umfasst:
- eine erste Stufe von Signal-Kombinierern, wobei die erste Stufe von Signal-Kombinierern einen oder mehrere Signal-Kombinierer, insbesondere einen oder mehrere 90°-Hybrid-Combiner, umfasst, wobei die Signal-Kombinierer der ersten Stufe von Signal-Kombinieren zwischen die Verstärkerzweige und den Ausgang geschaltet sind.

11. System nach einem der Ansprüche 9 und 10, wobei jeder Verstärkerzweig ferner eines der Schutzfilter umfasst.

12. Verwendung einer oder mehrerer Schaltungsanordnungen (100) in einem Verstärker für einen Teilchenbeschleuniger zum Schutz von Verstärkereinheiten (200) des Verstärkers vor vom Beschleunigungsresonator ausgehenden und in den Verstärkerausgang des Verstärkers laufenden Störsignalen, wobei die Schaltungsanordnung (100) Folgendes umfasst:
- eine Durchgangsfilterstrecke (10) zwischen einem ersten Ein- und/oder Ausgangsknoten (1) und einem zweiten Ein- und/oder Ausgangsknoten (2), wobei in der Durchgangsfilterstrecke (10) ein Durchgangsfilter mit einer Tiefpasscharakteristik angeordnet ist,
- eine erste Absorptionsfilterstrecke (20) zwischen dem zweiten Ein- und/oder Ausgangsknoten (2) und einem dritten Knoten (3), wobei in der ersten Absorptionsfilterstrecke (20) ein erstes Hochpassfilter angeordnet ist, und wobei an dem dritten Knoten (3) ein erster Lastwiderstand (21) angeordnet ist, und
- eine zweite Absorptionsfilterstrecke (30) zwischen dem ersten Ein- und/oder Ausgangsknoten (1) und einem vierten Knoten (4), wobei in der zweiten Absorptionsfilterstrecke (30) ein zweites Hochpassfilter angeordnet ist, und wobei an dem vierten Knoten (4) ein zweiter Lastwiderstand (31) angeordnet ist.

## Claims

1. System comprising:
- an apparatus, in particular a VHF amplifier or an amplifier module for a VHF amplifier, comprising one or more amplifier branches (300, 300'), and
- a particle accelerator, wherein an accelerator resonator of said particle accelerator is connected to an output of said apparatus, wherein each amplifier branch (300, 300') of said apparatus comprises an amplifier unit (200) and a circuit arrangement (100) which is arranged at the output of said amplifier unit, wherein said circuit arrangement (100) comprises the following:
- a pass-through filter section (10) between a first input and/or output node (1) and a second input and/or output node (2), wherein a pass-through filter with low-pass characteristics is arranged in said pass-through filter section (10),
- a first absorption filter section (20) between said second input and/or output node (2) and a third node (3), wherein a first high-pass filter is arranged in said first absorption filter section (20), and wherein a first load resistance (21) is arranged at said third node (3), and
- a second absorption filter section (30) between said first input and/or output node (1) and a fourth node (4), wherein a second high-pass filter is arranged in said second absorption filter section (30), and wherein a second load resistor (31) is arranged at said fourth node (4).

2. System according to Claim 1, wherein said pass-through filter and/or said first high-pass filter and/or said second high-pass filter are second or a higher order filters.

3. System according to any of Claims 1 and 2, wherein said pass-through filter and/or said first high-pass filter and/or said second high-pass filter are passive filters.

4. System according to any of Claims 1 to 3, wherein said pass-through filter is formed by at least two inductors (L1, L3) and at least one capacitor (C1) in a T-network, and/or wherein said first and second high-pass filter each are formed by at least two capacitors (C2, C3; C5, C6) and at least one inductor (L2; L6) in a T-network.

5. System according to any of Claims 1 to 4, wherein said first and second load resistors (21, 31) each match the characteristic impedance.

6. System according to any of Claims 1 to 5, wherein said apparatus comprises multiple amplifier branches.

7. System according to any of Claims 1 to 6, wherein said first or said second input and/or output node (1,2) of said circuit arrangement (100) are connected to the output of said amplifier unit (200).

8. System according to any of Claims 1 to 7, wherein each of the output signals of two or more amplifier branches (300, 300') of said one or more amplifier branches are combined by a signal combiner (520, 620), in particular a 90° hybrid combiner, to a single signal.

9. System according to any of Claims 1 to 8, wherein said apparatus further comprises the following:
- an output, and
- one or more protective filters, wherein said protective filters are inserted between said amplifier units of said amplifier branches and said output.

10. System according to Claim 9, wherein said apparatus further comprises the following:
- a first level of signal combiners, wherein said first level of signal combiners comprises one or more signal combiners, in particular one or more 90° hybrid combiners, wherein said signal combiners of said first level of signal combiners are arranged between said amplifier branches and said output.

11. System according to any of Claims 9 and 10, wherein each amplifier branch further comprises one of said protective filters.

12. Use of one or more circuit arrangements (100) in an amplifier for a particle accelerator for protecting the amplifier units (200) of said amplifier against interference signals emitted by the accelerator resonator and travelling to said amplifier, wherein said circuit arrangement (100) comprises the following:
- a pass-through filter section (10) between a first input and/or output node (1) and a second input and/or output node (2), wherein a pass-through filter with low-pass characteristics is arranged in said pass-through filter section (10),
- a first absorption filter section (20) between said second input and/or output node (2) and a third node (3), wherein a first high-pass filter is arranged in said first absorption filter section (20), and wherein a first load resistance (21) is arranged at said third node (3), and
- a second absorption filter section (30) between said first input and/or output node (1) and a fourth node (4), wherein a second high-pass filter is arranged in said second absorption filter section (30), and wherein a second load resistor (31) is arranged at said fourth node (4).

## Revendications

1. Système comprenant :
- un dispositif, en particulier un amplificateur VHF ou un module amplificateur pour un amplificateur VHF, comprenant une ou plusieurs branches d'amplificateur (300, 300'), et
- un accélérateur de particules,
sachant qu'un résonateur accélérateur de l'accélérateur de particules est relié à une sortie du dispositif, chaque branche d'amplificateur (300, 300') du dispositif comprenant une unité d'amplification (200) et un circuit de commutation (100), qui est disposé à la sortie de l'unité d'amplification, et sachant que le circuit de commutation (100) comprend :
- un parcours de filtre passe-bande (10) entre un premier noeud d'entrée et / ou de sortie (1) et un deuxième noeud d'entrée et / ou de sortie (2), sachant que, dans le parcours de filtre passe bande (10), est disposé un filtre passe bande qui présente une caractéristique passe bas,
- un premier parcours de filtre absorbant (20) entre le deuxième noeud d'entrée et / ou de sortie (2) et un troisième noeud (3), sachant que, dans le premier parcours de filtre absorbant (20), est disposé un premier filtre passe haut, et sachant que, dans le troisième noeud (3), est disposée une première résistance de charge (21), et
- un deuxième parcours de filtre absorbant (30) entre le deuxième noeud d'entrée et / ou de sortie (1) et un quatrième noeud (4), sachant que, dans le deuxième parcours de filtre absorbant (30), est disposé un deuxième filtre passe haut, et sachant que, dans le quatrième noeud (4), est disposée une deuxième résistance de charge (31).

2. Système selon la revendication 1, sachant que le filtre passe bande et / ou le premier filtre passe haut et / ou le deuxième filtre passe haut sont des filtres de deuxième ordre ou d'ordre supérieur.

3. Système selon revendication 1 et 2, sachant que le filtre passe bande et / ou le premier filtre passe haut et / ou le deuxième filtre passe haut sont des filtres passifs.

4. Système selon l'une des revendications 1 à 3, sachant que le filtre passe bande est formé par au moins deux bobines (L1, L3) et au moins un condensateur (C1) en circuit en T, et / ou sachant que le premier filtre passe haut et le deuxième filtre passe haut sont formés chacun par au moins deux condensateurs (C2, C3 ; C5, C6) et au moins une bobine (L2 ; L6) en circuit en T.

5. Système selon l'une des revendications 1 à 4, sachant que la première résistance de charge et la deuxième résistance de charge (21, 31) correspondent chacune à l'impédance caractéristique.

6. Système selon l'une des revendications 1 à 5, sachant que le dispositif est doté de plusieurs branches d'amplificateur.

7. Système selon l'une des revendications 1 à 6, sachant que le premier ou le deuxième noeud d'entrée et / ou de sortie (1, 2) du circuit de commutation (100) sont reliés à la sortie de l'unité d'amplification (200).

8. Système selon l'une des revendications 1 à 7, sachant que les signaux de sortie de deux ou plusieurs branches d'amplificateur (300, 300') sont respectivement réunis en un signal par un combineur de signaux (520, 620), en particulier par un combineur hybride 90 °.

9. Système selon l'une des revendications 1 à 8, sachant que le dispositif comprend de plus ce qui suit :
- une sortie et
- un ou plusieurs filtres protecteurs, sachant que les filtres protecteurs sont connectés entre les unités d'amplification des branches d'amplificateur et la sortie.

10. Système selon la revendication 9, sachant que le dispositif comprend de plus ce qui suit :
- un premier étage de combinaison de signaux, sachant que le premier étage de combinaison de signaux comprend un ou plusieurs combineurs de signaux, en particulier un ou plusieurs combineurs hybrides 90 °, sachant que le combineur de signaux du premier étage de combinaison de signaux est connecté entre la branche d'amplificateur et la sortie.

11. Système selon l'une des revendications 9 à 10, sachant que chaque branche d'amplificateur est dotée en plus d'un filtre protecteur.

12. Utilisation d'un ou de plusieurs circuits de commutation (100) dans un amplificateur pour un accélérateur de particules afin de protéger les unités d'amplification (200) de l'amplificateur contre des signaux parasites en provenance du résonateur d'accélération et en circulation dans la sortie de l'amplificateur, sachant que le circuit de commutation (100) comprend ce qui suit :
- un parcours de filtre passe bande (10) entre un premier noeud d'entrée et / ou de sortie (1) et un deuxième noeud d'entrée et / ou de sortie (2), sachant que, dans le parcours de filtre passe bande (10), est disposé un filtre passe bande qui présente une caractéristique passe bas,
- un premier parcours de filtre absorbant (20) entre le deuxième noeud d'entrée et / ou de sortie (2) et un troisième noeud (3), sachant que, dans le premier parcours de filtre absorbant (20), est disposé un premier filtre passe haut, et sachant que, dans le troisième noeud (3), est disposée une première résistance de charge (21), et
- un deuxième parcours de filtre absorbant (30) entre le deuxième noeud d'entrée et / ou de sortie (1) et un quatrième noeud (4), sachant que, dans le deuxième parcours de filtre absorbant (30), est disposé un deuxième filtre passe haut, et sachant que, dans le quatrième noeud (4), est disposée une deuxième résistance de charge (31).
